# EUROPÄISCHE PATENTSCHRIFT

(11) **EP 2 839 561 B1**
(45) Veröffentlichungstag und Bekanntmachung des Hinweises auf die Patenterteilung: **06.04.2016**
(21) Anmeldenummer: 13732798.7
(22) Anmeldetag: 10.04.2013
(51) Int. Cl.: H02G 3/08, B60L 11/18, H02J 7/00, H05K 5/00

(54) **LADEANSCHLUSSVORRICHTUNG FÜR ELEKTROFAHRZEUGE**
CHARGING CONNECTION DEVICE FOR ELECTRIC VEHICLES
DISPOSITIF DE CONNEXION DE CHARGE POUR VÉHICULES ÉLECTRIQUES

(30) Priorität: 13.04.2012 DE 202012101359 U
(43) Veröffentlichungstag der Anmeldung: 25.02.2015
(73) Patentinhaber: KEBA AG, 4041 Linz (AT)
(72) Erfinder: STARZINGER, Reinhard Gottlieb, A-4040 Linz (AT); WEIDINGER, Gerhard, A-4614 Marchtrenk (AT); QUARDT, Dirk, 58638 Iserlohn (DE); HERBOTE, Elke, 45549 Sprockhövel (DE)
(74) Vertreter: Burger, Hannes
(86) Internationale Anmeldenummer: PCT/AT2013/050085
(87) Internationale Veröffentlichungsnummer: WO 2013/152380

(56) Entgegenhaltungen:
- WO-A2-2011/107790
- WO-A2-2011/142685
- WO-A2-2011/157380
- CN-Y- 201 242 556

## Beschreibung

Die Erfindung betrifft eine Ladeanschlussvorrichtung für Elektrofahrzeuge, wie sie im Anspruch 1 angegeben ist.

Es ist allgemein bekannt, dass zum Aufladen bzw. Regenerieren des Energiespeichers eines elektrisch betriebenen Fahrzeuges ein solches Fahrzeug für eine gewisse Zeit abgestellt und mit einer elektrischen Energiequelle, üblicherweise dem örtlich vorhandenen Stromnetz, elektrisch verbunden wird. Moderne elektrische Fahrzeuge haben dabei mittlerweile eine akzeptable Reichweite von mehreren 100km, die mit einem voll aufgeladenen Energiespeicher zurückgelegt werden können, und weiters eine entsprechend hohe Antriebsleistung in der Größenordnung von 100kW, was eine komfortable und rasche Fortbewegung ermöglicht.

Im Vergleich zu Fahrzeugen, welche Verbrennungskraftmaschinen für den Antrieb nutzen und während nur sehr kurzer Stillstandszeit in der Regel mit einem flüssigen oder gasförmigen Energieträger betankt werden, dauert der Ladevorgang der heute für Elektrofahrzeuge üblichen elektrochemischen Energiespeicher relativ lange. Um die Einsatzzeit bzw. Verfügbarkeit eines elektrischen Fahrzeuges zu verbessern, wird daher danach getrachtet, die Ladezeit möglichst kurz zu halten, wofür jedoch während dem Ladevorgang eine erhebliche elektrische Leistung benötigt wird. Diese muss vom elektrischen Netz bezogen, typischerweise über die Ladeelektronik im Fahrzeug umgewandelt und schließlich in den Energiespeicher des Fahrzeuges übertragen werden. Die Größenordnung der Ladeleistung liegt heute im Bereich bis zu etwa 22kW und ist damit deutlich höher als die elektrische Leistung, die beispielsweise von einer üblichen Haushaltssteckdose bezogen werden kann. Elektrisch betriebene Kraftfahrzeuge stellen also im Vergleich zu anderen in Haushalten üblichen, elektrischen Verbrauchern durchaus Großverbraucher dar. Selbst wenn ein Stromanschluss mit prinzipiell ausreichend hoher elektrischer Anschlussleistung zur Verfiigung steht, kann es aufgrund der Gesamtbelastung in Teilen des Stromnetzes zu zeit- oder situationsabhängigen Einschränkungen bei der tatsächlich verfügbaren Leistung kommen.

Für den Ladevorgang elektrischer Kraftfahrzeuge - soweit es sich nicht um Kleinfahrzeuge in der Art eines Elekitofahrrades oder um Vergleichbares handelt - sind daher spezielle Ladeanschlussvorrichtungen erforderlich oder zumindest zweckmäßig, welche im Gegensatz zu einer herkömmlichen Steckdose nicht nur eine entsprechend hohe elektrische Anschlussleistung bereitstellen bzw. übertragen können, sondern auch zusätzliche Kommunikationsmittel aufweisen, mit denen die Ladeelektronik eines angeschlossenen Fahrzeuges die tatsächlich jeweils beziehbare Ladeleistung ermitteln kann bzw. auf die aktuelle Netzsituation reagieren kann, ohne das Netz bzw. die Zuleitung zu überlasten und damit eine Abschaltung zu verursachen. Weiters sind in solchen Ladeanschlussvorrichtungen eine Reihe von Sicherheitseinrichtungen implementiert, beispielsweise eine Sperrvorrichtung, die ein unbefugtes Abstecken oder ein Abstecken unter Volllast mit entsprechender Lichtbogenbildung verhindert. Die entsprechenden Ladeanschlussvorrichtungen sorgen typischerweise auch dafür, dass beim Auftreten von Fehlerströmen, bei Überlast und fallweise bei unzulässigen Rückspeiseströmen abgeschaltet bzw. entsprechend signalisiert wird.

Solche Ladeanschlussvorrichtungen können darüber hinaus Mittel zur Autorisierung des Energiebezugs beinhalten, beispielsweise via einen kodierten RFID-Transponder oder via einen Schlüsselschalter, oder technische Mittel umfassen, um den Benutzer zu identifizieren bzw. um Informationen für Verrechnungszwecke zu erfassen und gegebenenfalls diese Daten über datentechnische Netzwerkverbindungen mit zentralen Clearing-Stellen auszutauschen. Weiters können solche Ladeanschlussvorrichtungen auch Mittel zur Messung und Überwachung der übertragenen Leistung, des Stromes, oder der Energiemenge beinhalten. Der Stromanschluss, sowohl netzseitig als auch fahrzeugseitig, ist aufgrund der hohen zu übertragenden Leistung in der Regel als dreiphasiger bzw. mehrphasiger Starkstromanschluss mit entsprechend großen Leitungsquerschnitten von typisch 4 bis 6 mm², fallweise aber auch mit bis zu 16 mm² ausgeführt. Zweckmäßigerweise sind die Ladeanschlussvorrichtungen in unmittelbarer Nähe zu den Abstellplätzen der jeweiligen Elekttofahrzeuge installiert, wobei es sich üblicherweise um Garagen, Tiefgaragen, überdachte Parkflächen und dergleichen handelt, welche privat, fallweise aber auch öffentlich zugänglich oder zumindest für eine größeren Personenkreis zugänglich sein können.

Die WO 2011/157380 A2 offenbart eine stationäre Stromversorgungseinrichtung, wobei diese an einem Infrastrukturelement, welches als Straßenbeleuchtung ausgebildet ist, angebracht ist. Die Stromversorgungseinrichtung weist eine ein Gehäuse umfassende Ladevorrichtung zur elektrischen Aufladung wenigstens eines elektrischen Energiespeichers eines Fahrzeuges mit einem Elektroantrieb auf. Ein Verbindungsmittel dient der elektrischen Verbindung der Ladevorrichtung mit einem elektrischen Verbundnetzübergabepunkt. Ein Anschlussmittel für eine elektrische Anschlussverbindung der Ladevorrichtung mit dem am Fahrzeug vorhandenem Energiespeicher ist außerhalb des Gehäuses zugänglich. In einer Ausführungsvariante ist ein Ladeenergiespeicher ausgebildet, welcher in einem Gehäuse an der Straßenbeleuchtung integriert ist. Dieses Gehäuse, welches aus faserverstärktem Kunststoff gebildet ist, weist eine thermische Isolierung in Form eines polymeren Schaums auf, welcher in einen durch eine Doppelwandung des Gehäuses gebildeten Freiraum eingebracht ist Zusätzlich ist eine Ladezustandstibermittlungseinheit vorgesehen, welche als Balkenanzeige ausgebildet ist und in das Gehäuse integriert ist. Je nach Ladezustand des Ladeenergiespeichers sind alle Elemente der Balkenanzeige illuminiert bzw. in Abhängigkeit von einem reduzierten Ladezustand wird dieser durch eine reduzierte Anzahl von Balken ausgegeben.

Weitere Ladeanschlussvorrichtungen werden beispielsweise in den Druckschriften US 4,532,418 A, DE 42 13 414 C2, FR 2 766 950 A1, JP 11-122714 A, US 6,362,594 B2, WO 2007/141543 A2, WO 2010/011545 A1, WO 2010/133959 A2 und AT 507 605 A1 beschrieben.

Das Gehäuse solcher Ladeanschlussvorrichtungen muss dabei die hantierenden Personen vor dem Kontakt mit spannungsführenden Teilen im Innenraum bzw. vor lebensgefährlichen Stromschlägen schützen. Darüber hinaus schützt das Gehäuse die innenliegenden elektrischen und elektronischen Komponenten vor mechanischer Beschädigung sowie Schmutz und Feuchtigkeit und weiteren im Umfeld von Fahrzeugen zu erwartenden Stoffen, wie beispielsweise Streusalz oder vergleichbar wirkende Auftaumittel, und stellt damit deren dauerhaft zuverlässige Funktion sicher.

Um eine ausreichende Sicherheit für Personen und Sachwerte vor Stromschlag und Brand sicherzustellen, muss das Gehäuse eine hohe mechanische Festigkeit und zuverlässige Dichtheit aufweisen. Insbesondere muss es auch impulsartige Schläge bzw. den Aufprall von Gegenständen mit einer bestimmten Mindestenergie ohne diesbezügliche Sicherheitseinbußen überstehen können.

Den Lösungen nach dem Stand der Technik ist gemeinsam, dass sie in der Regel vergleichsweise aufwändig, vielfach schaltschrankartig aufgebaut sind bzw. einen hohen Fertigungs- und Montageaufwand erfordern und daher vergleichsweise teuer sind. Überdies weisen sie vielfach vergleichsweise große Abmessungen sowie ein hohes Gewicht auf. Die Gehäuse gemäß dem Stand der Technik sind, soweit sie den Anforderungen diverser einschlägiger Sicherheitsnormen überhaupt genügen, vielfach als massive Metallgehäuse ausgeführt, die bei entsprechender mechanischer Belastung zwar elastisch oder auch plastisch bis zu einem gewissen Grad deformiert werden, zumindest aber ihre Schutzfunktion weiterhin ausreichend erfüllen können, d.h. zumindest das Berühren spannungsführender Teile zuverlässig unterbinden können.

Eine derartige, gattungsgemäße Ladeanschlussvorrichtung für Elektrofahrzeuge ist in der US 6,316,908 B2 beschrieben. Die erforderlichen elektrotechnischen Komponenten der Ladeanschlussvorrichtung sind dabei in einem mehrteiligen Metallgehäuse untergebracht, welches aus einem schalenförmigen Basisteil, einem auf das Basisteil aufsetzbaren, haubenartigen Oberteil und aus einem seitlich andockbaren, schalenförmige Seitenteil aus Metall gebildet ist. Eine elektrische Leiterplatte und mehrere elektrotechnische Komponenten sind dabei im metallischen Basisteil gehaltert und werden im zusammengebauten Zustand des Gehäuses vom metallischen, haubenartigen Oberteil überstülpt Im haubenartigen Oberteil ist ein seitlicher Durchbruch ausgebildet, durch welchen Verbindungsdrähte von der Leiterplatte zu seitlich auf dem Oberteil montierten, weiteren elektrotechnischen Komponenten, wie einer Anzeigevorrichtung und einem Sensor, geführt werden. Die seitlich montierten elektrotechnischen Komponenten werden dann vom schalenförmigen Seitenteil aus Metall überdeckt. Im schalenförmigen Seitenteil sind schlitzförmige Durchbrüche ausgebildet, um die Anzeigevorrichtung einsehen zu können und einen Ladestecker der Ladeanschlussvorrichtung in seiner Bereitschafts- bzw. Ruheposition aufnehmen und den diese Bereitschafts- bzw. Ruheposition detektierenden Sensor aktivieren zu können. Mit diesen Maßnahmen wird eine robuste und elektromagnetisch gut abgeschirmte Ladeanschlussvorrichtung geschaffen. Unter anderem durch den hohen Fertigungsaufwand und den daraus bedingten Herstellkosten für eine solche Ladeanschlussvorrichtung ist deren Akzeptanz bzw. das erzielbare Marktpotential nur bedingt zufriedenstellend.

Die CN 201 242 556 Y offenbart eine Einphasen-Energiezilhler-Box mit einer transparenten Abdeckung. In die transparente Abdeckung sind mehrere Durchbrüche und Vertiefungen mit bedarfsweise entfernbaren oder öffenbaren Sichtfenstern bzw. Deckelelementen eingearbeitet.

Die WO 2011/107790 A2 offenbart eine Netzspannungsschnittstelle, welche in einem Gehäuse eingebettet ist, wobei am Gehäuse ein schwenkbarer Deckel angebracht ist, welcher entgegen einer Federkraft öffenbar ist und somit im geschlossenen Zustand die elektrischen Kontakte und das Gehäuseinnere vor Verschmutzung schützt. Zwischen Deckel und Gehäuse ist ein Dichtungselement eingebettet, sodass im geschlossenen Zustand des Deckels die Abdichtwirkung verbessert wird. In einer speziellen Ausführungsvariante sind im Inneren des Gehäuses Lichtquellen angeordnet, wobei im Deckel transparente oder transluzente Fensterelemente eingesetzt sind, durch welche das Licht der Lichtquellen nach außen gelangen werden kann.

Der vorliegenden Erfindung liegt die Aufgabe zugrunde, eine Ladeanschlussvorrichtung zu schaffen, welche möglichst kostengünstig produzierbar ist und dennoch einen hohen Funktionsumfang bzw. eine möglichst hohe Sicherheit, insbesondere in Bezug auf Personensicherheit bietet.

Diese Aufgabe der Erfindung wird durch die Maßnahmen gemäß Anspruch 1 gelöst. Vorteilhaft ist dabei, dass die entsprechende Ladeanschlussvorrichtung relativ kostengünstig bzw. besonders wirtschaftlich hergestellt werden kann. Insbesondere größere Stückzahlen an Ladeanschlussvorrichtungen können dadurch relativ wirtschaftlich gefertigt werden, nachdem die Aufnahmegehäuse zumindest teilweise, oder auch zur Gänze, durch Spritzgussteile aus Kunststoff gefertigt werden können und dabei trotzdem hohe sicherheitstechnische Anforderungen erfüllen. Die relativ wirtschaftliche Produzierbarkeit, vor allem bei größeren Stückzahlen, begünstigt dabei weiters die Erzielung eines möglichst niedrigen Verkaufs- bzw. Marktpreises, wodurch die Marktakzeptanz bzw. das Markipotential dieser Ladeanschlussvorrichtung zusätzlich gesteigert werden kann. Dennoch bietet die angegebene Ladeanschlussvorrichtung hohe technische Sicherheit, insbesondere hohe Sicherheit für damit hantierende Personen. Durch die angegebenen Maßnahmen können trotz Ausführung der dem Benutzer bzw. Bediener zugewandten Gehäusevorderseite als Kunststoffteil, hohe Sicherheitsanforderungen zuverlässig erfüllt werden. Insbesondere erzielt die angegebene Ladeanschlussvorrich tung hohe mechanische Robustheit und damit zuverlässigen Schutz vor einer allfälligen Berührung spannungsführender Teile durch anwesende bzw. hantierende Personen. Insgesamt weist die angegebene Ladeanschlussvorrichtung erhöhte, mechanische Beständigkeit, insbesondere Bruchfestigkeit gegenüber einem energiereichen Schlag oder Aufprall auf, sodass das Gehäuse anwesende bzw. hantierende Personen auch in derartigen Belastungsfällen zuverlässig vor einer die Gesundheit beeinträchtigenden oder lebensgefährlichen Berührung von spannungsführenden elektrischen und/oder elektronischen Komponenten bzw. Baugruppen schützen kann. Darüber hinaus ist die entsprechende Ladeanschlussvorrichtung trotz ihrer wirtschaftlichen Herstellbarkeit in problemloser Art und Weise optisch ansprechend gestaltbar, wodurch der Zusammenhang zwischen Marktanteil und Herstellungskosten bzw. Marktpreis zusätzlich begünstigt werden kann.

Ein besonderer Vorteil der erfindungsgemäßen Ausbildung liegt auch darin, dass durch den Einsatz von Kunststoff beim Benutzer bzw. Anwender ein inhärentes Gefühl von Sicherheit bzw. von Vertrauen erweckt wird, wenn das Gehäuse einer Ladeanschlussvorrichtung für Elektrofahrzeuge, durch welche hohe elektrische Leistungen bzw. gesundheitsgefährdende elektrische Spannungen, insbesondere Netzspannungen, bereitgestellt werden, zumindest abschnittsweise aus Kunststoff, vorzugsweise vollständig aus einem Kunststoff-Oberflächen aufweisenden Gehäuse, gebildet ist. Dieses positive Sicherheitsgefühl wird dabei bereits dann erweckt, wenn zumindest die exponierten Gehäuseabschnitte der Ladeanschlussvorrichtung, mit welchen der Bediener beim Hantieren typischerweise in Kontakt kommen kann, insbesondere die Gehäusevorderseite bzw. Gehäusefrontwand, aus einem elektrisch isolierenden Kunststoffteil gebildet sind. Die hohe elektrische Sicherheit bzw. Robustheit wird dabei in technischer Hinsicht insbesondere durch den begrenzt lichtdurchlässigen Kunststoff deutlich verbessert, sodass trotz eines relativ großvolumigen Gehäuses hohen Sicherheitsanforderungen in relativ kostengünstiger und zuverlässiger Art und Weise entsprochen werden kann. Der begrenzt lichtdurchlässige, gewissermaßen halbtransparente Kunststoff ermöglicht es dabei in vorteilhafter Art und Weise, optische Ausgabeelemente, welche von Personen visuell wahrzunehmen sind, ohne Durchbrüche in der Gehäusevorderseite bzw. ohne einem eigens eingesetzten Sichtfenster einsehbar zu machen. Durch die Vermeidung zusätzlicher Gehäuseöffnungen für optische Ausgabe- bzw. Anzeigeelemente wird vor allem die bei Stoßbelastungen bzw. bei dynamischen Krafteinwirkungen relativ kritische Kerbwirkung minimiert bzw. vermieden, wodurch die Robustheit bzw. Bruchfestigkeit des Gehäuses besonders vorteilhaft gesteigert wird. Die angegebenen Maßnahmen schützen daher in verbesserter Art und Weise vor einer sicherheitskritischen Beschädigung des Gehäuses und somit vor einer allfälligen Berührung spannungsführender Teile durch unwissende, unbedarfte oder unvorsichtige Personen. Weiters wird der Zusammenbau vereinfacht, da keinerlei Sichtfenster oder nach außen ragende Signalelemente eingebaut und abgedichtet werden müssen und auch die ansonsten damit einher gehenden Qualitätssicherungsmaßnahmen entfallen können. Dennoch kann ein hoher bzw. ausreichender Funktionsumfang der Ladeanschlussvorrichtung erzielt werden, nachdem die Informationen bzw. Signale des zumindest einen optischen Anzeige- oder Signalisierungsmittels von Personen visuell gut wahrnehmbar sind. Durch die begrenzte Lichtdurchlässigkeit des Kunststoffes werden darüber hinaus die elektrotechnischen Komponenten im Inneren der Ladeanschlussvorrichtung für den Anwender bzw. für sonstige Personen entweder gar nicht, nur schemenhaft oder nur teilweise ersichtlich, wodurch das optische Erscheinungsbild der Ladeanschlussvorrichtung positiv beeinflusst wird und damit einhergehend die Kosten- bzw. Marktsituation für die Ladeanschlussvorrichtung zusätzlich verbessert wird.

Von Vorteil sind auch die Maßnahmen gemäß Anspruch 2, da dadurch das erforderliche Ausmaß an Lichtdurchlässigkeit, insbesondere der entsprechende Wert zwischen Transparenz und Undurchsichtigkeit in einfacher Art und Weise voreingestellt bzw. festgelegt werden kann. Darüber hinaus ist Polycarbonat mit den für Thermoplaste üblichen Verfahren, insbesondere durch Spritzgussverfahren, gut verarbeitbar, wodurch eine rationelle, kostensparende Serienfertigung für mittlere bis große Stückzahlen ermöglicht ist. Ferner weisen Polycarbonate eine relativ hohe Festigkeit, Schlagzähigkeit, Steifigkeit und Härte auf, wodurch die Verwendung als Gehäusematerial für die Ladeanschlussvorrichtung zusätzliche Vorteile bringt. Außerdem sind Polycarbonate gute Isolatoren in Bezug auf elektrischen Strom, sodass auch dadurch ein vorteilhafter Effekt in Verbindung mit einer Ladeanschlussvorrichtung für Elektrofahrzeuge genutzt wird.

Durch die Maßnahmen gemäß Anspruch 3 kann der jeweils benötigten Lichtdurchlässigkeit bzw. Transluzenz in einfacher Art und Weise entsprochen werden bzw. kann dadurch den typischerweise vorherrschenden Umgebungslichtbedingungen einfach Rechnung getragen werden. Insbesondere kann dadurch ein optimierter Zwischenwert zwischen völliger Opazität und völliger Transparenz in einfacher und kostengünstiger Art und Weise eingestellt werden.

Durch die angegebene Beimengung von Farbstoff wird darüber hinaus das optische Erscheinungsbild der Oberfläche des damit hergestellten Kunststoffteils nicht negativ beeinflusst. Insbesondere können durch eine limitierte Beimengung von Farbstoff nachteilige Schlierenbildungen bzw. Reduzierungen der Bruchfestigkeit oder Schlagzähigkeit des grundsätzlich transparenten bzw. farblosen Polycarbonats vermieden bzw. hintan gehalten werden.

Vorteilhaft ist auch eine Ausführung nach Anspruch 4, da dadurch eine farbliche Veränderung oder Verfälschung des von zumindest einem Anzeige- oder Signalisierungsmittel abgestrahlten Lichtes minimal gehalten werden kann. Insbesondere kann dadurch vor allem bei einer mehrfarbigen Signalisierung eine bessere Unterscheidungskraft bzw. eine klarere Farbwiedergabe via die transluzente Gehäusefrontwand geboten werden.

Von besonderem Vorteil sind auch die Maßnahmen nach Anspruch 5, da dadurch der erste Gehäuseteil besonders kostengünstig erzeugt, insbesondere als Formteil gespritzt werden kann. Insbesondere ist dadurch ein aufwändiges Mehrkomponenten-Spritzgussverfahren erübrigt, wodurch die Herstellungskosten der Ladeanschlussvorrichtung möglichst niedrig gehalten werden können. Darüber hinaus werden Fensterabschnitte bzw. Scheibeneinbauten im ersten Gehäuseteil erübrigt, wodurch die Bruchfestigkeit des ersten Gehäuseteils gesteigert wird und die Produktionskosten möglichst niedrig gehalten werden können.

Durch die Maßnahmen gemäß Anspruch 6 werden in vorteilhafter Weise eine gute Robustheit, ein hohe Wirtschaftlichkeit, eine hohe Funktionalität, eine hohe Personensicherheit bzw. ein ausgezeichneter Berührungsschutz und ein optisch ansprechendes Erscheinungsbild der Ladeanschlussvorrichtung vereint.

Vorteilhaft ist auch eine Weiterbildung gemäß Anspruch 7, da dadurch der Anzeigeabschnitt der Ladeanschlussvorrichtung für Personen auch dann klar erkennbar ist, wenn keines der Anzeige- oder Signalisierungsmittel aktiviert ist. Somit kann von einer Bedienperson in einfacher Art und Weise erfasst werden, ob Statusmeldungen bzw. Signalisierungen vorliegen oder nicht. Insbesondere dann, wenn ein Anzeige- oder Signalisierungsmittel in seinem inaktiven Zustand durch den halbtransparenten Kunststoff des ersten Gehäuseteils nicht ersichtlich ist, kann eine solche Markierung nützlich sein, nachdem eine Nicht-Aktivierung bzw. ein unbeleuchteter Zustand für die Bedienperson ebenso eine relevante Information darstellen kann.

Durch wenigstens eine dauerhaft bzw. permanent angebrachte Markierung kann also der Informationsgehalt bzw. die Verständlichkeit der Signalisierungen für eine Bedienperson klarer gestaltet werden bzw. der Signalisierungsumfang des Anzeigeabschnittes der Ladeanschlussvorrichtung in einfacher Art und Weise gesteigert werden.

Von Vorteil sind auch die Maßnahmen gemäß Anspruch 8, da dadurch die Leuchtintensität zumindest von einzelnen Anzeige- oder Signalisierungsmitteln in einfacher Art und Weise gesteigert werden kann bzw. auch relativ lichtschwache und damit üblicherweise energiesparende Anzeige- oder Signalisierungsmittel vorteilhaft genutzt werden können. Dennoch behält der erste Gehäuseteil eine ausgezeichnete Dichtheit gegenüber Flüssigkeiten bzw. Schmutz und auch die Robustheit bzw. Bruchfestigkeit wird durch partiell reduzierte Wandstärken der Gehäusefrontwand nur marginal gesenkt.

Von besonderem Vorteil ist auch eine Weiterbildung gemäß Anspruch 9, da dadurch mit einfachen Mitteln relativ scharf abgegrenzte Leuchtflächen bzw. Signalisierungsabschnitte geschaffen werden können. Insbesondere werden dadurch diffus gestreute Leuchtflecken an der Gehäuseoberfläche vermieden bzw. hintan gehalten und kann damit die Anzeige- bzw. Signalisierungsqualität der Ladeanschlussvorrichtung in kostengünstiger und einfacher Art und Weise gesteigert werden. Insbesondere wird dadurch ohne Verwendung eines transparenten Sichtfensters bzw. ohne einem Gehäusedurchbruch ein relativ scharf begrenztes Erscheinungsbild des entsprechenden Licht- bzw. Leuchtflecks an der Gehäuseoberfläche bzw. der Gehäusefrontwand erzielt.

Vorteilhaft ist außerdem eine Weiterbildung nach Anspruch 10, da dadurch die Herstellungskosten möglichst gering gehalten werden können und zusätzliche, den logistischen und produktionstechnischen Aufwand erhöhende Elemente vermieden werden können. Vor allem dann, wenn die genannten Elemente an der Innenseite der Gehäusefrontwand angeformt sind, werden auch schmutzanfällige bzw. in Bezug auf Beschädigungen oder Verletzungen potentiell kritische Kanten an der Gehäuseoberfläche vermieden.

Durch die Maßnahmen gemäß Anspruch 11 werden Vorteile in Bezug auf hoher Anzeigequalität, niedrigen Produktionskosten und ausgezeichneter Funktionszuverlässigkeit erzielt. Weiters lassen sich durch die prozesstechnisch flexible, insbesondere linienartige oder flächenartige Anordnung der Leuchtdioden auf der Leiterplatte auf einfache Weise ansprechend geformte und harmonisch in das Gehäusedesign integrierte Lichtabstrahlungsflächen gestalten.

Bei den Maßnahmen gemäß Anspruch 12 ist von Vorteil, dass dadurch relativ punktuell abstrahlende Anzeige- oder Signalisierungsmittel, insbesondere Leuchtdioden mit einem begrenzten Abstrahlungswinkel, einen ausreichend großen, visuell klar erkennbaren Leuchtfleck an der Gehäuseoberseite abbilden können. Insbesondere kann dadurch mit relativ energiesparenden und besonders langlebigen Leuchtmitteln in Form von Leuchtdioden eine hohe Anzeigequalität und Zuverlässigkeit bzw. Robustheit der Ladeanschlussvorrichtung erzielt werden.

Von Vorteil sind auch die Maßnahmen gemäß Anspruch 13, da dadurch die Funktionalität bzw. die Interaktionstiefe gegenüber einer Bedienperson gesteigert werden kann, ohne die Robustheit bzw. die elektrische Sicherheit der Ladeanschlussvorrichtung zu beeinträchtigen. Insbesondere wird durch eine Vermeidung bzw. Reduzierung von Durchbrüchen im Gehäuse, insbesondere in der Gehäusefrontwand, die Bruchfestigkeit des Gehäuses verbessert. Neben einem ausgezeichneten Berührungsschutz gegenüber spannungsführenden Komponenten bietet das Gehäuse auch eine optimale Dichtheit gegenüber Flüssigkeiten bzw. Fremdkörpern. Darüber hinaus können durch diese berührungslos aktivier- bzw. beeinflussbaren Sensoren vorspringende Kanten, welche die Gefahr von Bruchkerben bzw. die Wahrscheinlichkeit von Schmutzansammlungen erhöhen, vermieden werden.

Durch die Ausbildung gemäß Anspruch 14 wird in Bezug auf die Herstellung bzw. Montage der Ladeanschlussvorrichtung eine gute Zugänglichkeit bzw. Zugreifbarkeit auf die im Inneren des Gehäuses angeordneten bzw. zu montierenden, elektrotechnischen Komponenten erzielt. Zudem wird die Bruchfestigkeit des ersten Gehäuseteils durch die Vermeidung von Durchbrüchen für optische Anzeige- und Signalisierungselemente gesteigert. Damit einhergehend wird der durch das Gehäuse bzw. durch den ersten Gehäuseteil erzielbare Berührungsschutz in Bezug auf elektrotechnische Komponenten, welche hohe bzw. sicherheitskritische elektrische Spannungen führen, verbessert. Gleichzeitig kann die Dichtheit eines entsprechend ausgebildeten Gehäuses auch langfristig sichergestellt werden.

Von Vorteil sind auch die Maßnahmen gemäß Anspruch 15, da dadurch alle festigkeits- bzw. stabilitätsrelevanten Abschnitte von dem eine Schutzfunktion übernehmenden Grundgehäuses vollständig aus Kunststoff gebildet sind, wodurch die Aufbaukosten vor allem bei einer Großserienfertigung der Ladeanschlussvorrichtung relativ gering gehalten werden können. Im Falle der Verwendung von glasfaserverstärktem Kunststoff wird die Bruchfestigkeit bzw. Schlagzähigkeit des Gehäuses nochmals deutlich verbessert, sodass auch hohen sicherheitstechnischen bzw. mechanischen Anforderungen problemlos Rechnung getragen werden kann.

Zum besseren Verständnis der Erfindung wird diese anhand der nachfolgenden Figuren näher erläutert.

Es zeigen jeweils in vereinfachter, beispielhafter Darstellung:
- Fig. 1: eine Ausführungsform der Ladeanschlussvorrichtung in perspektivischer Ansicht auf die Gehäusevorderseite;
- Fig. 2: die Ladeanschlussvorrichtung gemäß Fig. 1 in perspektivischer Ansicht auf die Gehäuserückseite;
- Fig. 3: die Ladeanschlussvorrichtung gemäß Fig. 1 in Explosionsdarstellung;
- Fig. 4: die Ladeanschlussvorrichtung gemäß Fig. 1 in Querschnittdarstellung im Bereich ihres Anzeige- oder Signalisierungsmittels;
- Fig. 5: die Ladeanschlussvorrichtung gemäß Fig. 1 im Längsschnitt;
- Fig. 6: ein Detail der Schnittdarstellung nach Fig. 5 im Bereich des Anzeige- oder Signalisierungsmittels der Ladeanschlussvorrichtung.

Einführend sei festgehalten, dass in den unterschiedlich beschriebenen Ausfüh-rungsformen gleiche Teile mit gleichen Bezugszeichen bzw. gleichen Bauteilbe-zeichnungen versehen werden, wobei die in der gesamten Beschreibung enthal-tenen Offenbarungen sinngemäß auf gleiche Teile mit gleichen Bezugszeichen bzw. gleichen Bauteilbezeichnungen übertragen werden können. Auch sind die in der Beschreibung gewählten Lageangaben, wie z.B. oben, unten, seitlich usw. auf die unmittelbar beschriebene sowie dargestellte Figur bezogen und sind diese Lageangaben bei einer Lageänderung sinngemäß auf die neue Lage zu übertragen.

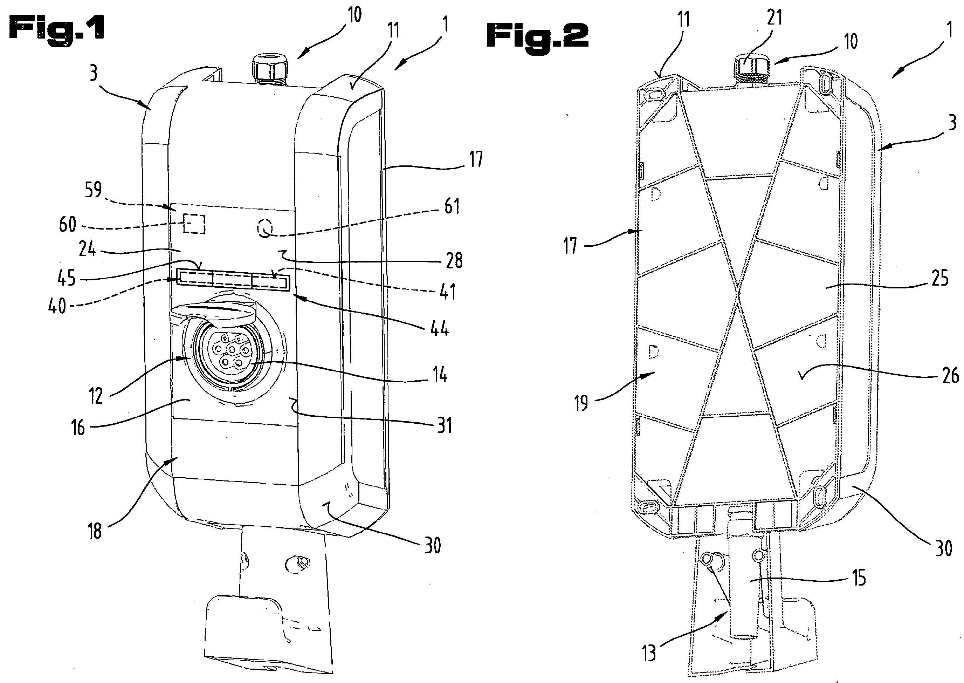

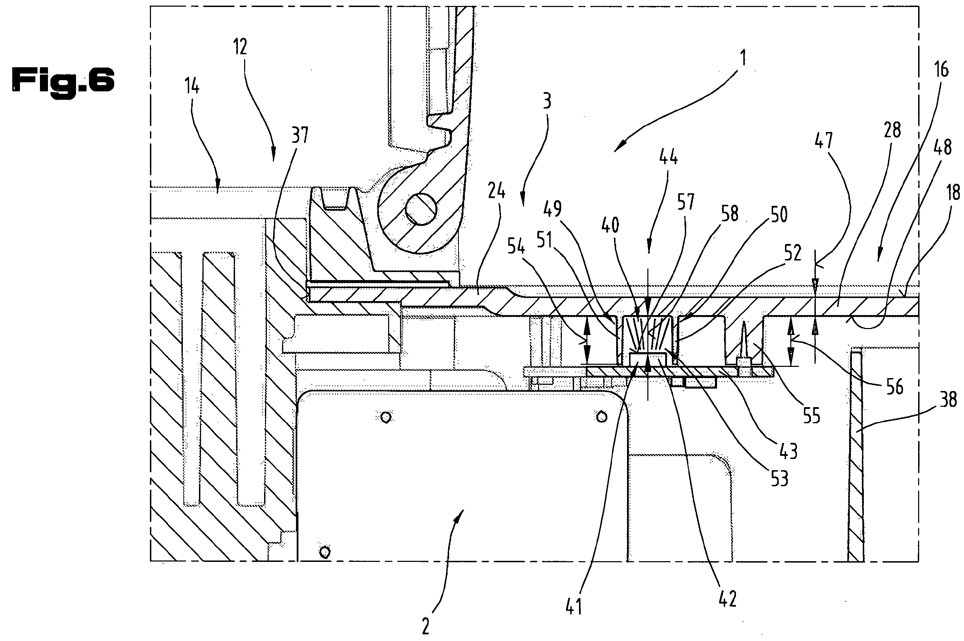

In den Fig. 1 bis 6 ist eine erfindungsgemäße Ausführungsform einer Ladeanschlussvorrichtung 1 für Elektrofahrzeuge veranschaulicht. Diese Ladeanschlussvorrichtung 1 ist zum Aufladen bzw. Regenerieren des Energiespeichers eines elektrisch betriebenen Fahrzeuges vorgesehen, indem die Ladeanschlussvorrichtung 1mit dem Energiespeicher bzw. der Ladeelektronik des Elektrofahrzeuges elektrisch verbunden wird. Die Ladeanschlussvorrichtung 1 ist dabei als Bezugsquelle für elektrische Energie zu verstehen, welche elektrische Energie in den wenigstens einen Energiespeicher eines Elektrofahrzeuges zu übertragen ist. Die Ladeanschlussvorrichtung 1 stellt vor allem dann, wenn die Ladeelektronik fahrzeugseitig eingebaut ist, eine Art von intelligenter Stromtankstelle für Elektrofahrzeuge dar. Gegebenenfalls ist es auch möglich, der Ladeanschlussvorrichtung 1 eine Ladeelektronik zuzuordnen bzw. in die Ladeanschlussvorrichtung 1 eine Ladeelektronik zu integrieren, welche die eingangsseitig eingespeiste, elektrische Energie in eine für die Aufladung des Energiespeichers im Elektrofahrzeug adäquate bzw. angepasste Form umwandelt und bereitstellt.

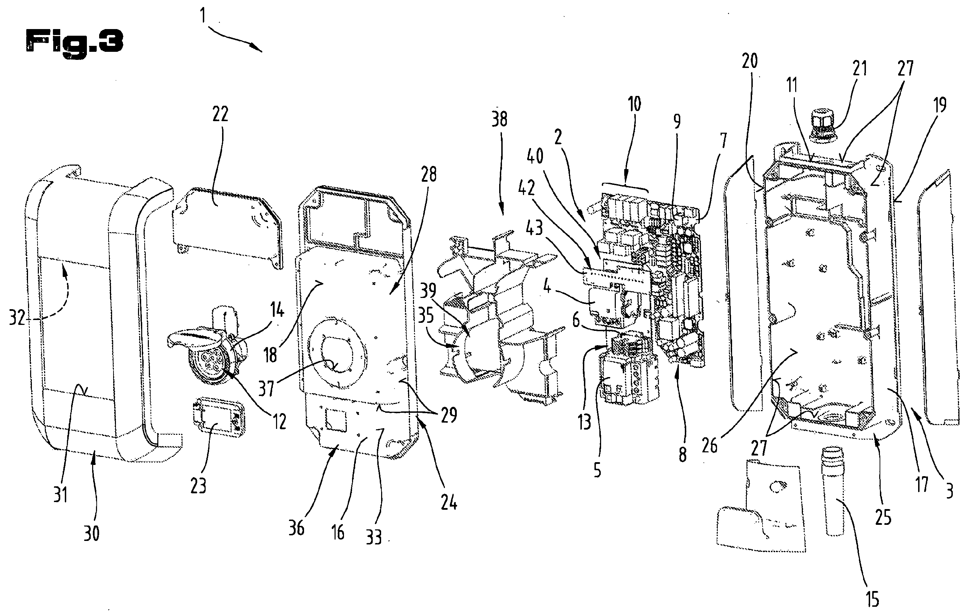

Wie am besten aus Fig. 3 ersichtlich ist, umfasst die Ladeanschlussvorrichtung 1 eine Mehrzahl von elektrotechnischen Komponenten 2, welche von einem mehrteiligen Gehäuse 3 umschlossen sind. Unter diesen elektrotechnischen Komponenten 2 sind auch elektronische Komponenten bzw. Baugruppen zu verstehen. Die elektrotechnischen Komponenten 2 dienen dabei zum Schalten und/oder Verteilen und/oder Messen und/oder Überwachen der aufgenommenen und/oder der abgegebenen, elektrischen Energie. Die elektrotechnischen Komponenten 2 können je nach Ausführungsform der Ladeanschlussvorrichtung 1 wenigstens eine Komponente ausgewählt aus der Bauteilgruppe umfassend Schütz 4, FI-Schutzschalter 5, Relais, Anschlussklemme 6, elektronischer Schaltkreis und dergleichen umfassen. Zu den elektrotechnischen Komponenten 2 zählen also auch elektronische Baugruppen. Die elektrotechnischen Komponenten 2 umfassen dabei zumindest eine sogenannte Printplatte bzw. Leiterplatte 7, auf welcher eine Mehrzahl von elektronischen Bauelementen zum Steuern und/oder Messen und/oder Überwachen der Energiezustände an der Ladeanschlussvorrichtung 1 bzw. im damit verbindbaren Elektrofahrzeug angeordnet sind. Insbesondere ist eine Steuer- und/oder Auswertevorrichtung 8 vorgesehen, welche zumindest teil-weise auf einer Leiterplatte 7 ausgebildet ist. Gegebenenfalls kann die Steuer- und/oder Auswertevorrichtung 8 wenigstens eine datentechnische Kommunikati-onsschnittstelle 9 - Fig. 3 - umfassen, über welche eine datentechnische Kommunikation der Steuer- und Auswertevorrichtung 8 bzw. der Ladeanschlussvorrichtung 1 mit peripheren, elektronischen bzw. elektrotechnischen Einheiten ermöglicht ist. Alternativ oder zusätzlich zu einer drahtgebundenen Kommunikationsschnittstelle 9 ist es selbstverständlich auch möglich, auf Funktechnologie basierende Kommunikationsschnittstellen vorzusehen.

Die Ladeanschlussvorrichtung 1 weist dabei wenigstens eine erste Schnittstelle 10 zur Zuführung bzw. Einspeisung von elektrischer Energie aus einem ortsfesten Stromversorgungsnetz auf. Insbesondere wird der Ladeanschlussvorrichtung 1 via diese erste Schnittstelle 10 die zur Weiterleitung an ein angeschlossenes Elektrofahrzeug benötigte, elektrische Energie zugeführt. Diese Schnittstelle 10 ist dabei als Leitungsschnittstelle ausgeführt, welche vorzugsweise zum Anschluss von Kabeladern vorgesehen ist. Um die typischerweise benötigte, elektrische Leistung zur bzw. in die Ladeanschlussvorrichtung 1 übertragen zu können, sind zumeist Kabelquerschnitte zwischen 4 bis 16 mm² vorgesehen. Die erste Schnittstelle 10 fungiert somit als Anschlussstelle für die elektrische Zuleitung. Die elektrische Energie wird dabei von einem einphasigen oder bevorzugt mehrphasigen Strom-versorgungsnetz mit standardisierter bzw. haushaltsüblicher Netzspannung bezogen, also beispielsweise im europäischen Raum in Höhe von 230 V AC bzw. 400 V AC. Beispielsgemäß erfolgt die Energiezuführung bzw. Stromzuleitung via wenigstens einen Durchbruch in der Gehäusedeckfläche 11 der Ladeanschlussvorrichtung 1. Selbstverständlich ist es auch möglich, die Seitenwände bzw. die Rückwand und/oder die Bodenplatte des Gehäuses 3 mit wenigstens einer Kabeldurchführung für die elektrische Zuleitung zu versehen.

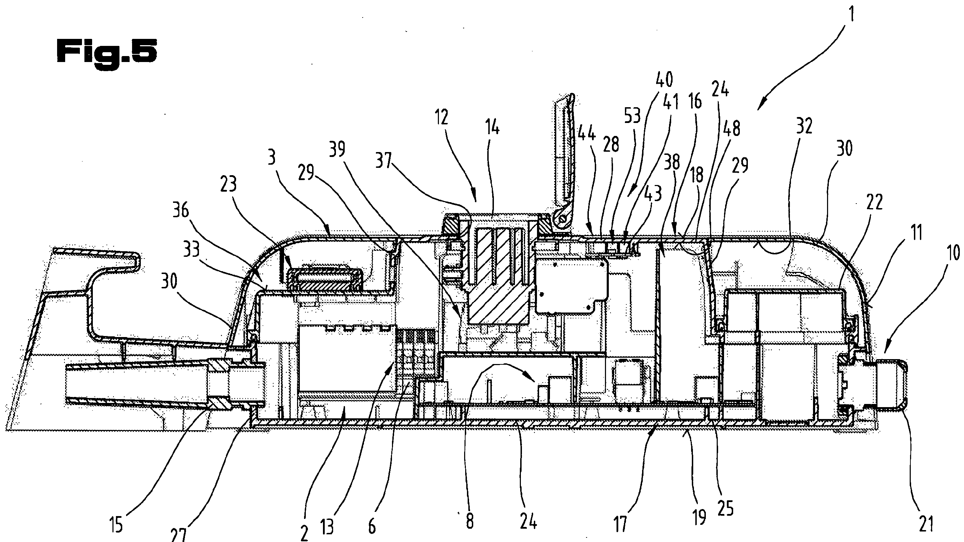

Die Ladeanschlussvorrichtung 1 umfasst darüber hinaus wenigstens eine zweite Schnittstelle 12, 13 zur gesteuerten bzw. kontrollierten Abgabe von elektrischer Energie an ein daran angeschlossenes Elektrofahrzeug. Diese zweite Schnittstelle 12, 13 kann dabei durch wenigstens eine Steckbuchse 14 und/oder durch wenigstens einen Kabelabgang bzw. durch Anschlussklemmen 6 - Fig. 3 - für Kabelenden gebildet sein. Insbesondere kann die zweite Schnittstelle 12 der Ladeanschlussvorrichtung 1 durch wenigstens eine Steckbuchse 14 und/oder wenigstens einen Kabelabgang 15 mit einem permanent angeschlossenen Ladekabel (nicht dargestellt) gebildet sein, um die von der Ladeanschlussvorrichtung 1 bereitgestellte bzw. jeweils verfügbare, elektrische Energie an ein damit verbundenes Elektrofahrzeug übertragen zu können. Bei der dargestellten Ausführung ist der Kabelabgang 15 mit einer Kabelhalterung - Fig. 3,5 - kombiniert, um eine geordnete Halterung von Restlängen bzw. der Gesamtlänge des Verbindungs- bzw. Ladekabels zu einem Elektrofahrzeug zu ermöglichen.

Um die elektrotechnischen Komponenten 2 möglichst rasch bzw. einfach im Ge-häuse 3 unterbringen bzw. einbauen zu können, ist es zweckmäßig, das Gehäuse 3 aus wenigstens einem ersten Gehäuseteil 16 und aus wenigstens einem weiteren Gehäuseteil 17 zu bilden. Entsprechend der dargestellten, zweckmäßigen Ausführungsform ist das Gehäuse 3 als Wandgehäuse ausgeführt, wobei der erste Gehäuseteil 16 zumindest einen Teilabschnitt der Gehäusevorderseite 18 ausbildet und der weitere Gehäuseteil 17 zumindest einen Teilabschnitt der Gehäuserückseite 19 definiert. Das aus wenigstens einem ersten, beispielsgemäß frontseitigen Gehäuseteil 16 und aus wenigstens einem weiteren, beispielsgemäß rückseitigen Gehäuseteil 17 zusammengesetzte Gehäuse 3 stellt dabei in Verbindung mit wenigstens einem Abdichtungselement 20, 21 sicher, dass die darin eingebauten elektrotechnischen Komponenten 2 vor einer Berührung durch Personen sowie vor Feuchtigkeit und Schmutz geschützt sind. Gegebenenfalls kann - wie schematisch dargestellt - zumindest am ersten bzw. vorderen Gehäuseteil 16 wenigstens ein bedarfsweise lösbarer bzw. bedarfsweise aufklappbarer Deckel 22, 23 vorgesehen sein, mit welchem ein teilweiser Zugriff bzw. eine partielle Einsichtnahme in das Gehäuseinnere, beispielsweise auf einen FI-Schutzschalter 5 oder einen Leitungsschutzschalter, ermöglicht ist.

Wesentlich ist, dass zumindest der erste Gehäuseteil 16, welcher wenigstens Teilabschnitte der Gehäusevorderseite 18 definiert, als formgespritzter Kunststoff-teil 24 ausgebildet ist. Insbesondere ist zumindest der erste Gehäuseteil 16 durch einen mittels einem Kunststoff-Spritzgießverfahren hergestellten Formkörper ge-bildet. Zweckmäßigerweise ist auch der weitere Gehäuseteil 17 als formgespritzter Kunststoffteil 25 ausgeführt. Alternativ ist es auch möglich, den weiteren Gehäuseteil 17, welcher zumindest Teilabschnitte der Gehäuserückseite 19 ausbildet, aus Metall oder aus einer Kombination von metallischen Werkstoffen und aus Kunststoff auszuführen. Es kann aber auch der erste bzw. frontseitige Gehäuseteil 16 aus metallischen Elementen, beispielsweise Schraub-Inserts oder Druckverteilungselemente, in Verbindung mit Kunststoff-Wandabschnitten gebildet sein. Die maßgeblich tragende bzw. statisch relevante Tragstruktur des ersten bzw. fronseitigen Gehäuseteils 16 wird dabei durch den formgespritzten Kunststoffteil 24 bewerkstelligt bzw. gewährleistet. Entsprechend einer zweckmäßigen Maßnahme kann der weitere Gehäuseteil 17 aus glasfaserverstärktem Kunststoff gebildet sein.

Der erste Gehäuseteil 16 und der weitere Gehäuseteil 17 bilden im plan- bzw. ordnungsgemäß zusammengesetzten Zustand einen Hohl- bzw. Innenraum zur Aufnahme der elektrotechnischen Komponenten 2 aus. Zweckmäßig ist es dabei, wenn der die Gehäuserückseite 19 definierende, weitere Gehäuseteil 17 schalenartig ausgeführt ist und die Gehäuserückwand 26 mit entlang von dessen Umfangsabschnitt verlaufenden Wandstegen 27 umfasst. Insbesondere bei einer rechteckigen Umrissform der Gehäuserückwand 26 sind vier entlang von dessen Umfangsabschnitt verlaufende Wandstege 27 ausgebildet, sodass ein schalenartiger Gehäuseteil 17 gebildet ist. Zweckmäßigerweise ist auch der die Gehäusevorderseite 18 definierende, erste Gehäuseteil 16 zumindest abschnittsweise schalen- oder deckelartig ausgeführt, wobei dieser erste Gehäuseteil 16 zumindest Teilabschnitte einer Gehäusefrontwand 28 der Ladeanschlussvorrichtung 1 ausbildet. Diese Gehäusefrontwand 28 ist dabei von einem Benutzer bzw. Bediener der Ladeanschlussvorrichtung 1 unmittelbar einseh- und zugreifbar. Die Gehäusefrontwand 28 weist gemäß der dargestellten, zweckmäßigen Ausführungsform entlang von dessen Umfangsabschnitt verlaufende Wandstege 29 auf, um den zumindest teilweise schalenartigen, ersten Gehäuseteil 16 zu definieren. Im dargestellten Ausführungsbeispiel stellt der erste Gehäuseteil 16 eine Kombination aus schalen- und deckelartigem Element in Bezug auf das an der Gehäuserückseite 19 vorgesehene, weitere Gehäuseteil 17 dar. Eine Trenn- bzw. Fügeebene zwischen dem ersten und dem weiteren Gehäuseteil 16, 17 ist vorzugsweise parallel zur Gehäusefrontwand 28 bzw. zur Gehäusevorderseite 18 ausgerichtet. Innerhalb dieser Trenn- bzw. Fügeebene ist wenigstens ein Abdichtungselement 20 vorgesehen, wie dies am besten aus Fig. 3 ersichtlich ist.

Zweckmäßig ist es dabei, wenn zumindest der festigkeitsrelevante, erste Gehäu-seteil 16, gegebenenfalls aber auch der weitere Gehäuseteil 17, zumindest ab-schnittsweise, insbesondere im Bereich der Kanten von einem käfig-, schalen- oder haubenartigen Verkleidungselement 30 überdeckt ist. Dieses Verkleidungs-element 30 ist dabei als partielle Überdeckung für Oberflächenabschnitte des ersten und/oder weiteren Gehäuseteils 16, 17 vorgesehen. Das Verkleidungselement 30 weist dabei wenigstens einen Durchbruch 31 auf, über welchen ein Teilabschnitt des ersten Gehäuseteils 16 zugreifbar bzw. freigestellt ist. Insbesondere wird durch diesen Durchbruch 31 ein Teilabschnitt der Gehäusevorderseite 18 gebildet bzw. ein Oberflächenabschnitt des ersten Gehäuseteils 16 für einen direkten Zugriff auf dessen Oberfläche freigestellt. Zweckmäßig ist es dabei, wenn die Gehäusefrontwand 28 im zusammengebauten Zustand des Gehäuses 3 im Wesentlichen bündig mit den Begrenzungskanten des Durchbruches 31 im Verkleidungselement 30 abschließt, wie dies am besten aus Fig. 1 ersichtlich ist.

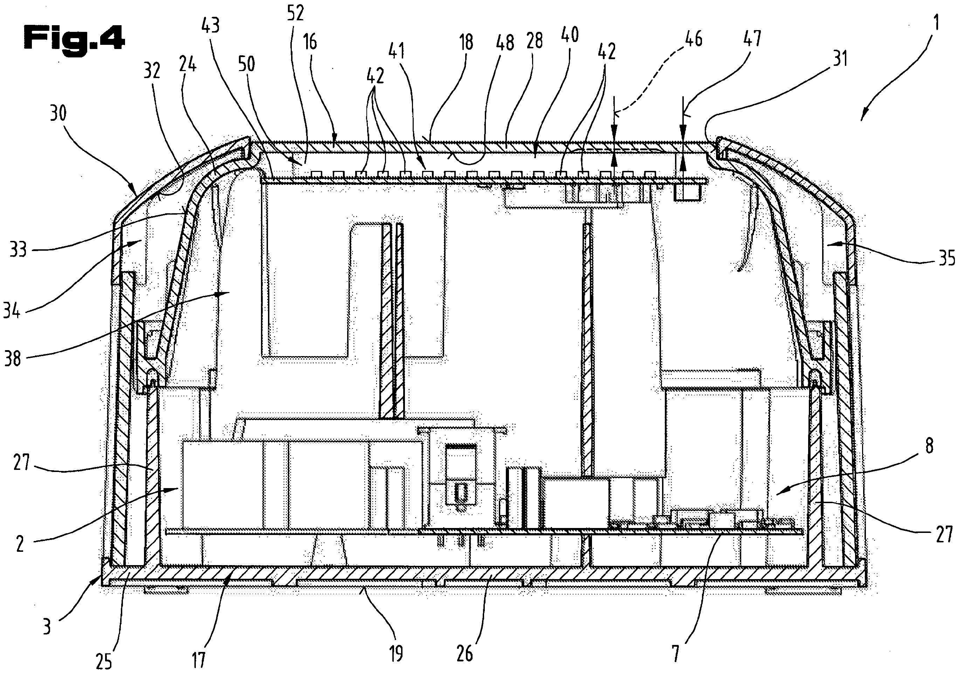

Wie am besten aus einer Zusammenschau der Fig. 3 und 4 ersichtlich ist, können entsprechend einer zweckmäßigen Ausführung zwischen der Innenseite 32 des Verkleidungselementes 30 und der Oberseite 33 des ersten Gehäuseteils 16 zumindest abschnittsweise Zwischenräume 34, 35, 36 ausgebildet sein. Während die Zwischenräume 34, 35 unter anderem Spielraum für Designvariationen des Gehäuses 3 bieten bzw. elastische Pufferzonen für erhöhte Robustheitsanforderungen darstellen, kann wenigstens ein Zwischenraum 36 - Fig. 3 - zwischen dem Verkleidungselement 30 und dem ersten Gehäuseteil 16 als Aufnahmeraum für hinter dem Verkleidungselement 30 verdeckt positionierte Klappen bzw. Deckel 22, 23 fungieren, wie dies am besten aus Fig. 3 ersichtlich ist. Durch einfaches Abnehmen des relativ filigran ausgebildeten Verkleidungselementes 30 - Fig. 1 - vom festigkeitsrelevanten Grundgehäuse umfassend den ersten und den weiteren Gehäuseteil 16, 17 besteht dann uneingeschränkter Zugriff auf ein bevorzugt werkzeuglos verstellbares Klappen- bzw. Deckelelement 22 für die Betätigung oder Rückstellung eines FI-Schutzschalters 5 bzw. auf einen durch Schrauben befestigten Deckel 22 zum örtlich begrenzten Zugriff auf ein Netzanschlussfach im Gehäuse 3 bzw. auf die erste Schnittstelle 10 mit den Anschlussklemmen für eine elektrische Zuleitung aus dem örtlichen Stromversorgungsnetz.

Bei der gezeigten Ausführungsform einer Ladeanschlussvorrichtung 1 mit einer in der Gehäusevorderseite 18 eingebauten Steckbuchse 14 kann im ersten Gehäuseteil 16 ein Durchbruch 37 ausgebildet sein, durch welchen die Steckbuchse 14 zumindest abschnittsweise in das Gehäuseinnere ragt, während deren Buchsenöffnung mit den elektrischen Steckkontakten ausgehend von der Gehäusevorderseite 18 zugreifbar ist. Die Steckbuchse 14 ist dabei einerseits durch die Randabschnitte um den Durchbruch 37 festgelegt und demzufolge am ersten, aus Kunststoff gebildeten Gehäuseteil 16 lastabtragend gehaltert, wie dies unter anderem aus den Fig. 1 und 3 ersichtlich ist. Vor allem dann, wenn die Ladeanschlussvorrichtung 1 eine mittels dem ersten Gehäuseteil 16 aus Kunststoff gehalterte Steckbuchse 14 aufweist, welche Steckbuchse 14 zu einem Stecker am Ladekabel eines Elektrofahrzeuges kompatibel ist, kann es zweckmäßig sein, wenn der dem Gehäuseinneren zugewandte Abschnitt der Steckbuchse 14 zusätzlich von einem im Innenraum des Gehäuses 3 angeordneten Formteil 38 umgrenzt wird und/oder davon gestützt wird.

Insbesondere kann ein im Gehäuseinneren positioniertes Formteil 38 zur zusätzlichen Abstützung bzw. zur verbesserten, lastabtragenden Halterung der Steckbuchse 14 vorgesehen sein. Alternativ oder in Kombination zu dieser Stützfunktion des Formteils 38 kann der Formteil 38 auch einen Aufnahme- bzw. Anschlussbereich 39 für nicht dargestellte, elektrische Anschlussleitungen zur Steckbuchse 14 definieren bzw. begrenzen. Dieser beispielsgemäß hohlzylindrisch ausgebildete Aufnahme- bzw. Anschlussbereich 39 ermöglicht eine geordnete und elektrisch abgegrenzte bzw. besser isolierende Unterbringung der elektrischen Anschlusskabel an der Rückseite der Steckbuchse 14.

Die Ladeanschlussvorrichtung 1 umfasst wenigstens ein steuerungstechnisches Ausgabeelement 40 zur Signalisierung von Betriebszuständen der Ladeanschlussvorrichtung 1 bzw. zur Anzeige von Ladezuständen des Energiespeichers im Elektrofahrzeug bzw. zur Visualisierung von betriebsrelevanten Daten der Ladeanschlussvorrichtung 1 gegenüber einem Benutzer, insbesondere gegenüber einer Wartungs- bzw. Bedienperson. Dieses wenigstens eine Ausgabeelement 40 umfasst hierfür wenigstens ein visuell wahrnehmbares, optisches Anzeige- oder Signalisierungsmittel 41, mit welchem einer Person diverse Betriebszustände, wie zum Beispiele Ladezustände, Ladezeiten, Ladefortschritte, Störungszustände, Auswahlmöglichkeiten, Quittierungsaufforderungen oder dergleichen mitgeteilt werden können.

Entsprechend einer zweckmäßigen Ausführungsform umfasst das optische Ausgabeelement 40, insbesondere dessen Anzeige- oder Signalisierungsmittel 41, eine Mehrzahl von Leuchtdioden 42, wie dies am besten aus Fig. 4 ersichtlich ist. Beispielsgemäß ist eine Zeilenanordnung mit einer Mehrzahl von Leuchtdioden 42 vorgesehen, um eine Art von Leuchtbalken bzw. Leuchtsegmenten mit selektiv ansteuerbaren bzw. gezielt aktivierbaren Leuchtpunkten zu erzielen. Diese Leuchtdioden 42 ermöglichen vorzugsweise farblich unterschiedliche Signalisierungen. Selbstverständlich ist auch eine beliebige andere Anordnung von Leuchtdioden 42 oder demgemäßen, andersartigen Leuchtmitteln möglich. Zweckmäßig ist es dabei, wenn die Leuchtdioden 42 zur Bildung des optischen Anzeige- oder Signalisierungsmittels 41 von einer gemeinsamen Leiterplatte 43 getragen werden und mit dieser Leiterplatte 43 elektrisch verbunden bzw. elektrisch verschaltet sind. Die entsprechende Ansteuerung bzw. selektive Aktivierung von Leuchtdioden 42 dieses Anzeige- oder Signalisierungsmittels 41 erfolgt zumindest teilweise durch die Steuer- und/oder Auswertevorrichtung 8 - Fig. 3 - der Ladeanschlussvorrichtung 1.

Zusätzlich zur Ausbildung von wenigstens einem optischen bzw. visuell erfassbaren Ausgabeelement 40 ist es selbstverständlich auch möglich, wenigstens ein akustisch wahrnehmbares Ausgabeelement, beispielsweise einen Summer, Lautsprecher oder dergleichen vorzusehen, um die Interaktion bzw. die insgesamt mögliche Informationsübermittlung an eine Bedienperson oder eine sonstige Person zu erweitern. Anstelle oder zusätzlich zu einem Anzeige- oder Signalisierungsmittel 41 mit einer Mehrzahl von Leuchtdioden 42 ist es selbstverständlich auch möglich, ausreichend lichtstarke 7-Segmentanzeigen oder sonstige Displays vorzusehen.

Wesentlich ist dabei, dass zumindest der erste Gehäuseteil 16, welcher zumindest Teilabschnitte der Gehäusevorderseite 18 bzw. der Gehäusefrontwand 28 definiert - Fig. 1 - durch einen formgespritzten Kunststoffteil 24 gebildet ist, dessen Kunststoff eine begrenzte bzw. vordefinierte Lichtdurchlässigkeit aufweist, insbesondere aus transluzentem Kunststoff gebildet ist, sodass eine Lichtabstrahlung von dem im Gehäuse 3 positionierten, optischen Anzeige- oder Signalisierungsmittel 41 via den Kunststoff dieses ersten Gehäuseteils 16 hindurch von einer Bedienperson bzw. einem Benutzer der Ladeanschlussvorrichtung 1 visuell wahrnehmbar ist. Das heißt, dass der Kunststoff des ersten Gehäuseteils 16 eine gewisse Durchsichtigkeit bzw. Lichtdurchlässigkeit aufweist, um eine vom optischen Anzeige- oder Signalisierungsmittel 41 aktiv abgegebene Lichtstrahlung visuell erfassen bzw. wahrnehmen zu können. Das heißt, dass der das Gehäuseteil 16 bildende Kunststoff, welcher zumindest Teilabschnitte der von der Bedienperson zugreifbaren bzw. ersichtlichen Gehäusevorderseite 18 definiert, durch einen transluzenten Kunststoff gebildet ist, der das von einem Anzeige- oder Signalisierungsmittel 41 im Inneren des Gehäuses 3 der Ladeanschlussvorrichtung 1 abgestrahlte Licht teilweise durchlässt. Dies wird durch die partielle Lichtdurchlässigkeit des Kunststoffes des ersten Gehäuseteils 16 bewerkstelligt. Der Kunststoff weist somit eine geringe Opazität auf bzw. ist er quasi halbtransparent ausgeführt, sodass er eine vorbestimmte Durchsichtigkeit aufweist.

Die Lichtdurchlässigkeit bzw. der sogenannte Lichttransmissionsgrad des ersten Gehäuseteils 16 ist zweckmäßigerweise derart festgelegt, dass von außen auf den Gehäuseteil 16 auftreffendes Umgebungs- bzw. Tageslicht zum überwiegenden Teil an der Gehäuseoberfläche reflektiert wird und nur ein vergleichsweise kleinerer Lichtanteil durchdringt. Insbesondere ist es zweckmäßig, wenn der Kunststoff des ersten Gehäuseteils 16 in seiner Lichtdurchlässigkeit derart begrenzt ist, dass bei normaler Umgebungshelligkeit, insbesondere bei Tageslicht, die dahinter liegenden elektrotechnischen Komponenten 2 nicht oder nur schemenhaft erkennbar sind, ein steuerungstechnisch aktiviertes bzw. aktiv Licht emittierendes, optisches Anzeige- oder Signalisierungsmittel 41 für eine Person jedoch visuell deutlich wahrnehmbar ist. Diese begrenzte Lichtdurchlässigkeit verhindert also eine einfache Einsichtnahme bzw. einen detaillierten Einblick auf die hinter dem ersten Gehäuseteil 16 positionierten, elektrotechnischen Komponenten 2. Dadurch kann das optische Erscheinungsbild bzw. der Gesamteindruck der Ladevorrichtung 1 für eine Bedienperson verbessert werden.

Darüber hinaus sind dadurch positive Auswirkungen auf die UV-Beständigkeit bzw. in Bezug auf eine Verzögerung von Vergilbung und Versprödung des Kunststoffs des ersten Gehäuseteils 16 bzw. im Hinblick auf die die dahinter liegenden, elektrotechnischen Komponenten 2 zu erwarten. Insbesondere wirkt sich eine gewisse UV-Filterung des ersten Gehäuseteils 16 positiv auf die UV-Stabilität der elektrotechnischen Komponenten 2 aus, was insbesondere bei starker Sonneneinstrahlung eine allmähliche Versprödung der Kunststoffe der elektrotechnischen Komponenten 2 bzw. des Gehäuses 3 hintan hält. Insbesondere kann dadurch die Zuverlässigkeit der Ladeanschlussvorrichtung 1 gesteigert bzw. eine möglichst langfristige Einsetzbarkeit der Ladeanschlussvorrichtung 1 erzielt werden. Darüber hinaus wird durch diese Maßnahmen die Robustheit des Gehäuses 3 der Ladeanschlussvorrichtung 1 verbessert, wobei diese erhöhte Robustheit durch Verbesserungen in Bezug auf die Bruchfestigkeit bzw. Kerbschlagzähigkeit und im Hinblick auf eine längerfristige Dichtheit bzw. Elastizität erzielt werden. Dennoch können visuell zu erfassende, optische Anzeige- oder Signalisierungsmittel für eine Bedien- bzw. Wartungsperson deutlich erkennbar bleiben. Der Grad an Lichtdurchlässigkeit bzw. Transluzenz ist dabei vom verwendeten, elektrisch isolierenden Kunststoff abhängig, welcher zumindest zur Formung des ersten Gehäuseteils 16 verwendet wird.

Zweckmäßig ist es, als Kunststoff zur Formung des ersten Gehäuseteils 16 einen thermoplastischen, in einem Spritzgießverfahren verarbeitbaren Kunststoff einzusetzen. Entsprechend einer zweckmäßigen Maßnahme ist der formgespritzte Kunststoffteil 24, welcher den ersten bzw. frontseitigen, schalen- oder deckelartigen Gehäuseteil 16 des Gehäuses 3 darstellt, durch ein transluzentes Polycarbonat gebildet. Der Kunststoff des ersten Gehäuseteils 16 ist somit durch ein grundsätzlich transparentes Polycarbonat mit geringer Opazität definiert. Demnach ist ein im Urzustand transparenter oder farbloser Kunststoff vorgesehen, welcher durch Beifügung von Farbstoff mit einem Volumsanteil von bis zu 2 %, vorzugsweise von bis zu 0,5 %, insbesondere von in etwa 0,2 % seine begrenzte Lichtdurchlässigkeit aufweist bzw. erhält. Die entsprechende Einfärbung des Polycarbonates erfolgt dabei zweckmäßigerweise vor der Verarbeitung einer entsprechenden Kunststoffmasse zum formgespritzten Gehäuseteil 16. Dadurch wird erreicht, dass der abdunkelnde bzw. tönende Farbstoff im Kunststoff des Gehäuseteils 16 möglichst homogen bzw. gleichmäßig verteilt ist.

Vorteilhaft ist die Verwendung weißer oder grauer Farbpigmente bzw. eine weiße oder graue Farbgebung des Gehäuseteils 16, da dadurch eine Veränderung oder Verfälschung der von dem Anzeige- oder Signalisierungsmittel 41 abgegebenen Lichtfarbe gering gehalten wird. Dies ist besonders relevant, wenn als Anzeige- oder Signalisierungsmittel 41 so genannte RGB-LEDs Verwendung finden und unterschiedliche Signalfarben für unterschiedliche darzustellende Informationen oder für unterschiedliche Designwünsche realisiert werden sollen.

Besonders zweckmäßig ist es dabei, wenn der erste bzw. frontseitige Gehäuseteil 16 des Gehäuses 3 vollständig aus dem begrenzt lichtdurchlässigen Kunststoff gebildet ist. Insbesondere kann der den Gehäuseteil 16 bildende Kunststoffteil 24 durchgehend aus dem begrenzt lichtdurchlässigen Kunststoff geschaffen sein. Das heißt, dass der erste Gehäuseteil 16 innerhalb seiner gesamten Oberfläche oder zumindest über den Großteil seiner Oberflächenabschnitte eine weitestgehend homogene Lichtdurchlässigkeit aufweist. Insbesondere in den Kantenabschnitten kann die Lichtdurchlässigkeit aufgrund von andersartigen Reflexionen bzw. Materialverdickungen geringfügig abweichen. Wesentlich ist, dass der erste Gehäuseteil 16, durch welchen wenigstens ein gesteuert aktivierbares Anzeige- oder Signalisierungsmittel 41 hindurchscheinen kann, aus einem Teil geformt bzw. gespritzt ist, wobei dieser Kunststoffteil 24 vorzugsweise zur Gänze aus einem transluzenten Kunststoff bzw. Polycarbonat aufgebaut bzw. erzeugt ist.

Der erste Gehäuseteil 16 bildet dabei zumindest einen Teilabschnitt der äußeren Gehäusefrontwand 28 des Gehäuses 3 aus, wie dies am besten aus einer Zusammenschau der Fig. 1 und 3 ersichtlich ist. Diese Gehäusefrontwand 28 ist dabei für eine Bedienperson unmittelbar zugreifbar bzw. unmittelbar einsehbar, wie dies im Ausführungsbeispiel gemäß Fig. 1 exemplarisch dargestellt wurde. In dieser transluzenten Gehäusefrontwand 28 ist wenigstens ein Anzeigeabschnitt 44 definiert. Hinter diesem Anzeigeabschnitt 44, das heißt auf der dem Innenraum des Gehäuses 3 zugewandten Seite der Gehäusefrontwand 28, ist das zumindest eine optische Anzeige- oder Signalisierungsmittel 41 positioniert, um in diesem Anzeigeabschnitt 44 durch den transluzenten Kunststoff der Gehäusefrontwand 28 bzw. des ersten Gehäuseteils 16 hindurchleuchten zu können.

Dabei kann auch vorgesehen sein, dass der wenigstens eine Anzeigeabschnitt 44 oder Teilabschnitte des zumindest einen Anzeigeabschnittes 44 durch zumindest eine am Gehäuseteil 16 bzw. an der Gehäusefrontwand 28 dauerhaft angebrachte Markierung 45 visuell erkennbar gemacht sind. Durch diese zumindest eine Markierung 45 ist der Anzeigeabschnitt 44 der Ladeanschlussvorrichtung 1 auch dann erkennbar, wenn keines der Anzeige- oder Signalisierungsmittel 41 aktiviert ist und somit im Anzeigeabschnitt 44 keine Signalisierung erfolgt. Insbesondere kann dadurch in einfacher Art und Weise festgestellt werden, wo die entsprechenden Anzeige- oder Signalisierungsmittel 41 im transluzenten Gehäuse 3 positioniert sind bzw. ob eine aktive Signalisierung vorliegt oder nicht. Insbesondere können durch diesen permanent markierten Anzeigeabschnitt 44 bzw. durch die Markierung von Teilabschnitten des Anzeigeabschnittes 44 allfällige Missverständnisse vermieden werden bzw. kann dadurch die Klarheit über das Vorliegen oder Nichtvorliegen einer Signalisierung verbessert werden. Diese zumindest eine Markierung 45 kann beispielsweise durch eine strukturelle Vertiefung oder Erhebung im Kunststoff des ersten Gehäuseteils 16 gebildet sein. Besonders vorteilhaft ist es, anstelle von strukturellen Vertiefungen oder Erhebungen wenigstens eine grafische Kennzeichnung, beispielsweise einen Aufdruck oder einem Aufkleber vorzusehen, über welchen der zumindest eine Anzeigeabschnitt 44 visuell erkennbar gemacht wird. Durch eine grafische Kennzeichnung wird insbesondere die Bruchfestigkeit des ersten Gehäuseteils 16 möglichst hoch gehalten, nachdem nachteilige Kerbwirkungen durch strukturelle Vertiefungen bzw. Erhebungen vermieden sind.

In Abhängigkeit der zu erzielenden Robustheit bzw. Bruchfestigkeit kann auch vorgesehen sein, dass der erste Gehäuseteil 16 in wenigstens einem visuell zu erfassenden Anzeigeabschnitt 44 innerhalb der Gehäusefrontwand 28 eine geringere Wandstärke 46 - mit strichlierten Linien angedeuteter Abschnitt in Fig. 4 - aufweist, als die reguläre bzw. übliche Wandstärke 47 in einem daran anschließenden Abschnitt der Gehäusefrontwand 28. Insbesondere kann durch eine partiell reduzierte Wandstärke 46 zumindest in einem Teilabschnitt des Anzeigeabschnittes 44 die Intensität der Signalisierung, insbesondere die Lichtintensität von dahinterliegenden Anzeige- oder Signalisierungsmitteln 41 gesteigert werden. Anstelle der partiellen Reduzierung der Wandstärke 46 der Gehäusefrontwand 28 ist es selbstverständlich auch möglich, Anzeige- oder Signalisierungsmittel 41 mit unterschiedlicher Lichtintensität vorzusehen, um unterschiedliche Signalisierungsarten bzw. um unterschiedliche Signalisierungsintensitäten, beispielsweise für Stör- oder Warnmeldungen, zu erzielen.

Entsprechend einer vorteilhaften Ausgestaltung, wie sie am besten aus den Fig. 4 bis 6 ersichtlich ist, kann der erste Gehäuseteil 16 an seiner dem Gehäuseinneren zugewandten Innenseite 48 wenigstens eine Lichtblende 49, 50 oder wenigstens ein Lichtleitelement zur Begrenzung oder Fokussierung des vom Anzeige- oder Signalisierungsmittel 41 abstrahlbaren Lichtes aufweisen. Eine solche Lichtblende 49, 50 kann dabei durch wenigstens einen Begrenzungssteg 51, 52 gebildet sein, welcher eine diffuse Lichtausbreitung, ausgehend vom Anzeige- oder Signalisierungsmittel 41, insbesondere ausgehend von dessen Leuchtdioden 42, hintan hält. Diese Lichtleitblenden 49, 50 bzw. die dementsprechenden Begrenzungsstege 51, 52 können dabei aus dem gleichen Kunststoff gebildet sein, aus dem auch der erste Gehäuseteil 16 bzw. die Gehäusefrontwand 28 gebildet ist. Das heißt, dass die Begrenzungsstege 51, 52 für das sich vom Anzeige- oder Signalisierungsmittel 41 ausbreitende Licht ebenso aus transluzentem Polycarbonat gebildet sein können. Besonders zweckmäßig ist es, wenn das wenigstens eine Lichtleitelement bzw. die wenigstens eine Lichtblende 49, 50, welche vorzugsweise steg- bzw. rippenartig ausgeführt ist, am ersten Gehäuseteil 16, insbesondere an dessen Innenseite 48, einstückig angeformt ist. Dadurch bildet die wenigstens eine Lichtblende 49, 50 einen integralen Bestandteil der Gehäusefrontwand 28 aus. Zweckmäßig ist es dabei, zwei zueinander beabstandete, stegartige Begrenzungsstege 51, 52 vorzusehen, zwischen welchen ein Lichtkanal 53 für das von wenigstens einem Anzeige- oder Signalisierungsmittel 41 abstrahlbare Licht definiert wird. Diese stegartigen Lichtblenden 49, 50 weisen bevorzugt eine Wandstärke bzw. Dicke auf, welche deutlich geringer ist, als die Wandstärke 47 der Gehäusefrontwand 28. Eine Höhe 54 der Lichtblenden 49, 50 bzw. der Begrenzungsstege 51, 52 kann demgegenüber ein Mehrfaches, insbesondere das Zwei- bis Fünffache der Wandstärke 47 der Gehäusefrontwand 28 betragen. Typischerweise beträgt die Höhe 54 zwischen 3 mm und 12 mm, insbesondere in etwa 8 mm. Die Wandstärke 47 beträgt demgegenüber zweckmäßigerweise zwischen 1,5 bis 4 mm, vorzugsweise in etwa 2,5 mm.

Die Leiterplatte 43 zur Aufnahme bzw. Halterung der Anzeige- oder Signalisierungsmittel 41, insbesondere der Leuchtdioden 42, ist vorzugsweise über wenigstens einen an der Innenseite 48 der Gehäusefrontwand 28 angeformten Haltefortsatz 55 in einer Distanz 56 zur Innenseite 48 der Gehäusefrontwand 28 gehaltert. Dieser Haltefortsatz 55 stellt vorzugsweise ebenso einen einstückigen bzw. integralen Bestandteil des ersten Gehäuseteils 16 dar. Die Distanz 56 entspricht dabei in etwa der Höhe 54 der Begrenzungsstege 51, 52 des Lichtkanals 53. Zweckmäßig ist es dabei, wenn eine Lichtabstrahlungsfläche 57 des optischen Anzeige- oder Signalisierungsmittels 41 in einem Abstand 58 von weniger als 15 mm, vorzugsweise zwischen 2 und 8 mm, insbesondere 6 mm zur Innenseite 48 der transluzenten bzw. halbtransparenten Gehäusefrontwand 28 distanziert ist. Dadurch wird eine verbesserte Lichtausbreitung ausgehend von der Lichtabstrahlungsfläche 57 der Anzeige- oder Signalisierungsmittel 41 ermöglicht. Dennoch wird eine adäquate Fokussierung bzw. Ausleuchtung des Lichtkanals 53 und damit einhergehend eine relativ scharfe Abgrenzung des Leuchtflecks bzw. des Leuchtbildes an der Außenseite der transluzenten Gehäusefrontwand 28 erzielt.

Ein Vorteil der angegebenen Maßnahmen liegt darin, dass in dem von einem Benutzer der Ladeanschlussvorrichtung 1 unmittelbar zugreifbaren Teilabschnitt der Gehäusefrontwand 28 keinerlei Durchbrüche für optische Signalisierungs- bzw. Ausgabeelemente 40 ausgebildet sind, durch welche ein optisches Ausgabeelement 40 gehaltert wird bzw. durch welche die Lichtabstrahlung eines optischen Ausgabeelementes 40 erfolgen würde. Vielmehr wird die Lichtabstrahlung durch den transluzenten Kunststoff hindurch bewerkstelligt und durch die Anordnung des jeweiligen optischen Ausgabeelementes 40 knapp hinter der Gehäusefrontwand 28 eine mechanische Durchbrechung desselben erübrigt. Dadurch wird die Robustheit bzw. Bruchfestigkeit und auch Dichtheit des ersten Gehäuseteils 16 bzw. des kompletten Gehäuses 3 erheblich verbessert. Insbesondere bei Stoßbelastungen wird die Gefahr eines Kerbbruches, insbesondere die Kerbwirkung bzw. Kerbspannung im Kunststoff des ersten bzw. frontseitigen Gehäuseteils 16 minimiert.

Gegebenenfalls kann die Ladeanschlussvorrichtung 1 wenigstens ein steuerungstechnisches Eingabeelement 59 umfassen. Dieses wenigstens eine Eingabeelement 59 ermöglicht eine Beeinflussung des Betriebsverhaltens bzw. der Betriebszustände der Ladeanschlussvorrichtung 1. Insbesondere in Verbindung mit zumindest einem der Ausgabeelemente 40 ist dabei eine Interaktion zwischen der Ladeanschlussvorrichtung 1 und einer Bedien- bzw. Wartungsperson ermöglicht. Entsprechend einer vorteilhaften Ausführung ist das wenigstens eine Eingabeelement 59 durch wenigstens einen berührungslos aktivier- oder beeinflussbaren Sensor 60, 61 - Fig. 1 - gebildet. Beispielsweise kann ein solcher berührungslos aktiver- oder beeinflussbarer Sensor 60, 61 durch zumindest einen Näherungsdetektor gebildet sein, welcher auf Lichtreflexionen, auf Induktivitätsänderungen und/oder auf Kapazitätsänderungen, oder auf Infrarot- oder Wärmestrahlung reagiert bzw. diesbezüglich sensitiv ist. Durch Annäherung des Fingers oder der Hand der Bedienperson kann sodann eine entsprechendes Sensorsignal beeinflusst und diese Zustandsänderung von der Steuer- und/oder Auswertevorrichtung 8 - Fig. 3 - ausgewertet bzw. verarbeitet werden. Wesentlich ist dabei, dass dieses berührungslos aktivier- oder beeinflussbare Eingabeelement 59 im Gehäuseinneren angeordnet ist und dabei hinter einem unterbrechungs- oder durchbruchsfrei ausgeführten Abschnitt der Gehäusefrontwand 28 positioniert ist. Insbesondere sind hierfür keinerlei Durchbrüche in der Gehäusefrontwand 28 aus Kunststoff erforderlich. Derartige Durchbrüche würden die Robustheit und gegebenenfalls die Dichtheit des Gehäuses 3 aufgrund erhöhter Kerbbruchwirkung negativ beeinträchtigen. Darüber hinaus ist durch eine Erübrigung von Durchbrüchen in Zusammenhang mit allfälligen Eingabeelementen 59 aber auch in Zusammenhang mit dem wenigstens einen optischen Ausgabeelement 40 eine verringerte Beschädigungsgefahr der Ladeanschlussvorrichtung 1 im Hinblick auf Feuchtigkeit oder Schmutzpartikel gegeben. Jedenfalls wird durch die angegebenen Maßnahmen die Bruchfestigkeit und damit einhergehend der erzielbare elektrische Berührungsschutz des aus Kunststoff gebildeten Gehäuses 3 der Ladeanschlussvorrichtung 1 deutlich verbessert.

Entsprechend einer zweckmäßigen Maßnahme kann auch vorgesehen sein, wenigstens ein sensorisches Eingabeelement 59 und wenigstens ein optisches Anzeige- oder Signalisierungsmittel 41 zu überlagern. Insbesondere können zumindest ein Anzeigeabschnitt bzw. ein Teilabschnitt des Anzeigeabschnittes 44 und ein Eingabe- bzw. Betätigungsabschnitt der Ladeanschlussvorrichtung örtlich überlagert bzw. kombiniert sein. Durch eine derartige Maßnahme wird in einfacher Art und Weise ein quasi hinterleuchtetes bzw. rückmeldendes Eingabeelement 60 geschaffen. Die Bedienerfreundlichkeit bzw. die Übersichtlichkeit des Benutzerinterface der Ladeanschlussvorrichtung 1 kann dadurch in einfacher Art und Weise verbessert werden.

Die Ausführungsbeispiele zeigen mögliche Ausführungsvarianten der Ladeanschlussvorrichtung 1, wobei an dieser Stelle bemerkt sei, dass die Erfindung nicht auf die speziell dargestellten Ausführungsvarianten derselben eingeschränkt ist, sondern vielmehr auch diverse Kombinationen der einzelnen Ausführungsvarianten untereinander möglich sind und diese Variationsmöglichkeit aufgrund der Lehre zum technischen Handeln durch gegenständliche Erfindung im Können des auf diesem technischen Gebiet tätigen Fachmannes liegt. Es sind also auch sämtliche denkbaren Ausführungsvarianten, die durch Kombinationen einzelner Details der dargestellten und beschriebenen Ausführungsvariante möglich sind, vom Schutzumfang mit umfasst.

Sämtliche Angaben zu Wertebereichen in gegenständlicher Beschreibung sind so zu verstehen, dass diese beliebige und alle Teilbereiche daraus mit umfassen, z.B. ist die Angabe 1 bis 10 so zu verstehen, dass sämtliche Teilbereiche, ausgehend von der unteren Grenze 1 und der oberen Grenze 10 mitumfasst sind, d.h. sämtliche Teilbereiche beginnen mit einer unteren Grenze von 1 oder größer und enden bei einer oberen Grenze von 10 oder weniger, z.B. 1 bis 1,7, oder 3,2 bis 8,1 oder 5,5 bis 10.

Vor allem können die einzelnen in den Fig. 1 bis 6 gezeigten Ausführungsdetails den Gegenstand von eigenständigen, erfindungsgemäßen Lösungen bilden. Die diesbezüglichen, erfindungsgemäßen Aufgaben und Lösungen sind den Detailbeschreibungen dieser Figuren zu entnehmen.

**Bezugszeichenaufstellung**

| | | | |
|---|---|---|---|
| 1 | Ladeanschlussvorrichtung | 36 | Zwischenraum |
| 2 | elektrotechn. Komponenten | 37 | Durchbruch |
| 3 | Gehäuse | 38 | Formteil |
| 4 | Schütz | 39 | Aufnahme- bzw. Anschlussbereich |
| 5 | FI-Schutzschalter | 40 | Ausgabeelement |
| | | | |
| 6 | Anschlussklemme | 41 | Anzeige- oder Signalisierungsmittel |
| 7 | Leiterplatte | | |
| 8 | Steuer- und/oder Auswertevorrichtung | 42 | Leuchtdiode |
| | | 43 | Leiterplatte |
| 9 | Kommunikationsschnittstelle | 44 | Anzeigeabschnitt |
| 10 | erste Schnittstelle | 45 | Markierung |
| | | | |
| 11 | Gehäusedeckfläche | 46 | Wandstärke |
| 12 | zweite Schnittstelle | 47 | Wandstärke |
| 13 | zweite Schnittstelle | 48 | Innenseite |
| 14 | Steckbuchse | 49 | Lichtblende |
| 15 | Kabelabgang | 50 | Lichtblende |
| | | | |
| 16 | erstes Gehäuseteil | 51 | Begrenzungssteg |
| 17 | weiteres Gehäuseteil | 52 | Begrenzungssteg |
| 18 | Gehäusevorderseite | 53 | Lichtkanal |
| 19 | Gehäuserückseite | 54 | Höhe |
| 20 | Abdichtungselement | 55 | Haltefortsatz |
| | | | |
| 21 | Abdichtungselement | 56 | Distanz |
| 22 | Deckel | 57 | Lichtabstrahlungsfläche |
| 23 | Deckel | 58 | Abstand |
| 24 | Kunststoffteil | 59 | Eingabeelement |
| 25 | Kunststoffteil | 60 | Sensor |
| | | | |
| 26 | Gehäuserückwand | 61 | Sensor |
| 27 | Wandsteg | | |
| 28 | Gehäusefrontwand | | |
| 29 | Wandsteg | | |
| 30 | Verkleidungselement | | |
| | | | |
| 31 | Durchbruch | | |
| 32 | Innenseite | | |
| 33 | Oberseite | | |
| 34 | Zwischenraum | | |
| 35 | Zwischenraum | | |

## Patentansprüche

1. Ladeanschlussvorrichtung (1) für Elektrofahrzeuge, mit wenigstens einer ersten Schnittstelle (10) zur Einspeisung von elektrischer Energie aus einem ortsfesten Stromversorgungsnetz in die Ladeanschlussvorrichtung (1), mit wenigstens einer zweiten Schnittstelle (12) zur gesteuerten Abgabe von elektrischer Energie an ein Elektrofahrzeug, mit einer Mehrzahl von elektrotechnischen Komponenten (2) zum Schalten, Messen oder Überwachen der aufgenommenen und/oder der abgegebenen elektrischen Energie, mit einem die elektrotechnischen Komponenten (2) umschließende, mehrteiligen Gehäuse (3), welches zumindest aus einem ersten und einem weiteren Gehäuseteil (16, 17) zusammengesetzt ist, wobei das Gehäuse (3) und Abdichtungselemente (20,21) die darin eingebauten elektrotechnischen Komponenten (2) vor einer Berührung durch Personen sowie vor Feuchtigkeit und Schmutz schützen, und mit wenigstens einem steuerungstechnischen Ausgabeelement (40) zumindest zur Signalisierung von Zuständen der Ladeanschlussvornchtung (1) gegenüber einer Bedienperson, wobei zumindest der erste Gehäuseteil (16), welcher zumindest Teilabschnitte der Gehäusevorderseite (18) definiert, als formgespritzter Kunststoffteil (24) ausgebildet ist, **dadurch gekennzeichnet, dass** der Kunststoff zur Bildung zumindest des ersten Gehäuseteils (16) eine begrenzte Lichtdurchlässigkeit aufweist, sodass eine Lichtabstrahlung eines im Gehäuse (3) positionierten, optischen Anzeige- oder Signalisierungsmittels (41) via den Kunststoff des ersten Gehäuseteils (16) hindurch visuell wahrnehmbar ist.

2. Ladeanschlussvorrichtung nach Anspruch 1, **dadurch gekennzeichnet, dass** der Kunststoff durch ein transluzentes Polycarbonat gebildet ist.

3. Ladeanschlussvorrichtung nach Anspruch 1 oder 2, **dadurch gekennzeichnet, dass** der Kunststoff im Urzustand transparent oder farblos ist und durch Beifügung von Farbstoff mit einem Volumsanteil von bis zu 2%, vorzugsweise von bis zu 0,5%, insbesondere von in etwa 0,2% seine begrenzte Lichtdurchlässigkeit aufweist.

4. Ladeanschlussvorrichtung nach Anspruch 3, **dadurch gekennzeichnet, dass** der Farbstoff weiße oder graue Farbpigmente umfasst, sodass zumindest der erste Gehäuseteil (16) eine weiß oder grau erscheinende Farbtönung aufweist.

5. Ladeanschlussvorrichtung nach einem der vorhergehenden Ansprüche, **dadurch gekennzeichnet, dass** der erste Gehäuseteil (16) als schalenförmiger Kunststoffteil (24) ausgebildet ist und durchgehend aus dem begrenzt lichtdurchlässigen Kunststoff gebildet ist.

6. Ladeanschlussvorrichtung nach einem der vorhergehenden Ansprüche, **dadurch gekennzeichnet, dass** der erste Gehäuseteil (16) zumindest einen Teilabschnitt einer Gehäusefrontwand (28) des Gehäuses (3) ausbildet, und dass in dieser Gehäusefrontwand (28) wenigstens ein Anzeigeabschnitt (44) definiert ist, hinter welchem zumindest ein Anzeige- oder Signalisierungsmittel (41) positioniert ist.

7. Ladeanschlussvorrichtung nach Anspruch 6, **dadurch gekennzeichnet, dass** der Anzeigeabschnitt (44) oder Teilabschnitte des Anzeigeabschnittes (44) durch zumindest eine dauerhafte Markierung (45), beispielsweise durch eine strukturelle Vertiefung, Erhebung oder durch eine grafische Kennzeichnung, visuell erkennbar gemacht sind.

8. Ladeanschiussvtirrichtung nach einem der vorhergehenden Ansprüche, **dadurch gekennzeichnet, dass** der erste Gehäuseteil (16) in wenigstens einem visuell erfassbaren Anzeigeabschnitt (44) innerhalb einer Gehäusefrontwand (28) eine geringere Wandstärke (46) aufweist, als in einem daran anschließenden Abschnitt der Gehäusefrontwand (28).

9. Ladeanschlussvorrichtung nach einem der vorhergehenden Ansprüche, **dadurch gekennzeichnet, dass** der erste Gehäuseteil (16) an seiner dem Innenraum zugewandten Innenseite (48) wenigstens eine Lichtblende (49, 50) oder wenigstens ein Lichtleitelement zur Begrenzung oder Fokussierung des vom Anzeige- oder Signalisierungsmittel (41) abstrahlbaren Lichtes aufweist.

10. Ladeanschlussvorrichtung nach Anspruch 9, **dadurch gekennzeichnet, dass** die wenigstens eine Lichtblende (49, 50) oder das wenigstens eine Lichtleitelement am ersten Gehäuseteil (16) einstückig abgeformt ist und einen integralen Bestandteil einer Gehäusefrontwand (28) darstellt.

11. Ladeanschlussvorrichtung nach einem der vorhergehenden Ansprüche, **dadurch gekennzeichnet, dass** das optische Anzeige- oder Visualisierungsmittel (41) eine Mehrzahl von Leuchtdioden (42) umfasst, welche von einer gemeinsamen Leiterplatte (43) getragen und mit der Leiterplatte (43) elektrisch verbunden sind.

12. Ladeanschlussvorrichtung nach Anspruch 11, **dadurch gekennzeichnet, dass** eine Lichtabstrahlungsfläche (57) des optischen Anzeige- oder Signalisierungstnittels (41) in einem Abstand (58) von weniger als 15 mm, vorzugsweise zwischen 2 mm und 8 mm, insbesondere etwa 6 mm zur Innenseite (48) des ersten Gehäuseteils (16) distanziert ist.

13. Ladeanschlussvorrichtung nach einem der vorhergehenden Ansprüche, **dadurch gekennzeichnet, dass** sie steuerungstechnische Eingabeelemente (59) zur Beeinflussung des Betriebsverhaltens der Ladeanschlussvorrichtung (1) umfasst, welche Eingabeelemente (59) durch berührungslos aktivier- oder beeinflussbare Sensoren (60, 61), beispielsweise durch Lichtreflexionen, Induktivitäts- oder Kapazitätsänderungen oder Infrarot- oder Warmestrahlung auswertende Näherungsdetektaren, gebildet sind, welche im Gehäuseinneren hinter einem unterbrechungs- oder durchbruchsfrei ausgeführten Abschnitt einer Gehäusefrontwand (28), welche durch den ersten Gehäuseteil (16) gebildet ist, angeordnet sind.

14. Ladeanschlussvorrichtung nach einem der vorhergehenden Ansprüche, **dadurch gekennzeichnet, dass** der erste Gehäuseteil (16) schalen- oder deckelartig ausgeführt ist und zumindest einen Teilabschnitt einer Gehfiusefrontwand (28) der Ladeanschlussvorrichtung (1) ausbildet, wobei in diesem von einem Benutzer der Ladeanschlussvorrichtung (1) zugreifbaren Teilabschnitt der Gehäusefrontwand (28) keine Durchbrüche für optische Anzeige- oder Signalisierungselemente (41) ausgebildet sind.

15. Ladeanschlussvorrichtung nach einem der vorhergehenden Ansprüche, **dadurch gekennzeichnet, dass** der weitere Gehäuseteil (17) zumindest die Gehäuserückwand (26) ausbildet und als formgespritzter Kunststoffteil (25) ausgeführt ist, insbesondere aus glasfaserverstärktem Kunststoff gebildet ist.

## Claims

1. Charging connection device (1) for electric vehicles, having at least a first interface (10) for feeding electrical energy from a stationary power supply network into the charging connector device (1), having at least one second interface (12) for the controlled delivery of electrical energy to an electric vehicle, having a plurality of electrotechnical components (2) for switching, measuring or monitoring the electrical energy received and/or delivered, having a multi-part housing (3) that surrounds the electrotechnical components (2) and is composed of at least a first and another housing part (16, 17), wherein the housing (3) and sealing elements (20, 21) protect the electrotechnical components (2) installed therein from being touched by persons and from moisture and dirt, and having at least one control output element (40) at least for signalling states of the charging connection device (1) to an operator, wherein at least the first housing part (16), which defines at least subsections of the housing front side (18), is an injection moulded plastic part (24), **characterized in that** the plastic for forming at least the first housing part (16) has a limited degree of translucency, so that the emission of light by an optical display or signalling means (41) positioned in the housing (3) is visible through the plastic of the first housing part (16).

2. Charging connection device according to claim 1, **characterized in that** the plastic is formed by a translucent polycarbonate.

3. Charging connection device according to either of claims 1 or 2, **characterized in that** in its original state the plastic is transparent or colourless, and the limited degree of translucency thereof is achieved by adding dye in a volume fraction of up to 2%, preferably up to 0.5%, particularly approximately 0.2%.

4. Charging connection device according to claim 3, **characterized in that** the dye comprises white or grey colour pigments, so that at least the first housing part (16) appears to have a white or grey tint.

5. Charging connection device according to any one of the preceding claims, **characterized in that** the first housing part (16) is in the form of a tray-shaped plastic part (24) and is continuously formed from the plastic having limited translucency.

6. Charging connection device according to any one of the preceding claims, **characterized in that** the first housing part (16) forms at least a subsection of a housing front wall (28) of the housing (3), and that at least one display section (44) is defined in said housing front wall (28), behind which display section at least one display or signalling means (41) is positioned.

7. Charging connection device according to claim 6, **characterized in that** the display section (44) or subsections of the display section (44) are made visually perceptible by at least one permanent marking (45), for example by a structural depression, elevation, or by a graphical mark.

8. Charging connection device according to any one of the preceding claims, **characterized in that** the first housing part (16) in at least one visually detectable indicator portion (44) has a smaller wall thickness (46) in one housing front wall (28) than in an adjacent section of the housing front wall (28).

9. Charging connection device according to any one of the preceding claims, **characterized in that** the inner side (48) of the first housing part (16) facing the interior thereof has at least one light diffuser (49, 50) or at least one light guiding element for limiting or focusing the light that can be emitted by the display or signalling means (41).

10. Charging connection device according to claim 9, **characterized in that** the at least one light diffuser (49, 50) or the at least one light guiding element is conformed as a single part with the first housing part (16) and represents an integral part of a housing front wall (28).

11. Charging connection device according to any one of the preceding claims, **characterized in that** the optical display or signalling means (41) comprises a plurality of light emitting diodes (42) which are supported by a common printed circuit board (43) and are electrically connected to the printed circuit board (43).

12. Charging connection device according to claim 11, **characterized in that** a light emitting surface (57) of the optical display or signalling means (41) is located at a distance (58) of less than 15 mm, preferably between 2 mm and 8 mm, particularly about 6 mm from the inner side (48) of the first housing part (16).

13. Charging connection device according to any one of the preceding claims, **characterized in that** it includes control input elements (59) for influencing the operating behaviour of the charging connection device (1), which input elements (59) are formed by sensors (60, 61) that can be activated or influenced without contact, for example by proximity detectors that evaluate light reflections, changes in inductance or capacitance, or infrared or thermal radiation, and which are arranged in the housing interior behind a continuous or uninterrupted section of a housing front wall (28), which is formed by the first housing part (16).

14. Charging connection device according to any one of the preceding claims, **characterized in that** the first housing part (16) is designed as a tray or cover and forms at least a subsection of a housing front wall (28) of the charging connection device (1), wherein no gaps for optical display or signalling elements (41) are created in this subsection of the housing front wall (28) that is accessible to a user of the charging connection device (1).

15. Charging connection device according to any one of the preceding claims, **characterized in that** the further housing part (17) forms at least the housing rear wall (26), and has the form of an injection moulded plastic part (25), particularly from glass-fibre reinforced plastic.

## Revendications

1. Dispositif de connexion de charge (1) pour des véhicules électriques, comprenant : au moins une première interface (10) destinée à introduire de l'énergie électrique provenant d'un réseau d'alimentation en courant fixe dans le dispositif de connexion de charge (1), au moins une deuxième interface (12) permettant la distribution commandée d'énergie électrique à un véhicule électrique, une pluralité de composants électrotechniques (2) permettant de commuter, de mesurer ou de surveiller l'énergie électrique absorbée et/ou distribuée, et un boîtier (3) en plusieurs parties entourant les composants électrotechniques (2), lequel est assemblé à partir de première et seconde parties de boîtier (16, 17), dans lequel le boîtier (3) et des éléments d'étanchéité (20, 21) protègent les composants électrotechniques (2) montés à l'intérieur vis-à-vis d'un contact avec des personnes, ainsi que de l'humidité et de la saleté, et ayant au moins un élément de sortie à logique de commande (40) permettant au moins de signaliser des états du dispositif de connexion de charge (1) à un opérateur, dans lequel au moins la première partie de boîtier (16), qui définit au moins des sections partielles de la face avant (18) du boîtier, est réalisée sous la forme d'une pièce en matière plastique (24) moulée par injection, **caractérisée en ce que** la matière plastique permettant de former au moins la première partie de boîtier (16) présente une transparence limitée, de sorte qu'une émission de lumière d'un moyen d'affichage ou de signalisation optique (41) positionné dans le boîtier (3) est perceptible visuellement à travers la matière plastique de la première partie de boîtier (16).

2. Dispositif de connexion de charge selon la revendication 1, **caractérisé en ce que** la matière plastique est formée par un polycarbonate translucide.

3. Dispositif de connexion de charge selon la revendication 1 ou 2, **caractérisé en ce que** la matière plastique est transparente ou incolore à l'état d'origine et voit sa transmission de lumière limitée par adjonction d'un colorant à une fraction volumique d'au plus 2 %, de préférence d'au plus 0,5 %, en particulier d'environ 0,2 %.

4. Dispositif de connexion de charge selon la revendication 3, **caractérisé en ce que** le colorant comprend des pigments blancs ou gris, de sorte qu'au moins la première partie de boîtier (16) présente une tonalité chromatique apparente de couleur blanche ou grise.

5. Dispositif de connexion de charge selon l'une quelconque des revendications précédentes, **caractérisé en ce que** la première partie de boîtier (16) est réalisée sous la forme d'une pièce en matière plastique en forme de coupelle (24), et est formée en continue à partir de la matière plastique à transmission de lumière limitée.

6. Dispositif de connexion de charge selon l'une quelconque des revendications précédentes, **caractérisé en ce que** la première partie de boîtier (16) forme au moins une section partielle d'une paroi avant de boîtier (28) du boîtier (3), et **en ce qu'**au moins une section d'affichage (44) est définie dans cette paroi avant (28), derrière laquelle au moins un moyen d'affichage ou de signalisation optique (41) est positionné.

7. Dispositif de connexion de charge selon la revendication 6, **caractérisé en ce que** la section d'affichage (44) ou des sections partielles de la section d'affichage (44) sont réalisées visuellement reconnaissables par au moins un marquage permanent (45), par exemple par une cavité structurelle, une saillie ou par un étiquetage graphique.

8. Dispositif de connexion de charge selon l'une quelconque des revendications précédentes, **caractérisé en ce que** la première partie de boîtier (16), dans au moins une section d'affichage visuellement reconnaissable (44) dans une paroi avant de boîtier (28), présente une épaisseur de paroi (46) moindre que dans une section contiguë de la paroi avant de boîtier (28).

9. Dispositif de connexion de charge selon l'une quelconque des revendications précédentes, **caractérisé en ce que** la première partie de boîtier (16) présente, sur sa face intérieure (48) donnant sur l'espace intérieur, au moins un masque de lumière (49, 50) ou au moins un élément de guidage de lumière afin de limiter ou de focaliser la lumière émise par le moyen d'affichage ou de signalisation optique (41).

10. Dispositif de connexion de charge selon la revendication 9, **caractérisé en ce que** le au moins un masque de lumière (49, 50) ou le au moins un élément de guidage de lumière est formé en un seul bloc avec la première partie de boîtier (16), et est une partie intégrante d'une paroi avant de boîtier (28).

11. Dispositif de connexion de charge selon l'une quelconque des revendications précédentes, **caractérisé en ce que** le moyen d'affichage ou de signalisation optique (41) comprend une pluralité de diodes électroluminescentes (42), lesquelles sont supportées par une carte de circuits imprimés (43), et reliées électriquement à la carte de circuits imprimés (43).

12. Dispositif de connexion de charge selon la revendication 11, **caractérisé en ce qu'**une surface d'émission de lumière (57) du moyen d'affichage ou de signalisation optique (41) est éloignée de la face intérieure (48) de la première partie de boîtier (16) d'une distance (58) inférieure à 15 mm, de préférence comprise entre 2 mm et 8 mm, notamment d'environ 6 mm.

13. Dispositif de connexion de charge selon l'une quelconque des revendications précédentes, **caractérisé en ce qu'**il comprend des éléments d'entrée à logique de commande (59) pour influencer le comportement de fonctionnement du dispositif de connexion de charge (1), lesquels éléments d'entrée (59) sont formés par l'intermédiaire de capteurs activés ou influencés sans contact (60, 61), par exemple par des reflets de lumière, des changements d'inductance ou de capacité, ou par détecteurs de proximité évaluant des rayonnements infrarouges ou thermiques, lesquels sont agencés à l'intérieur, derrière une section réalisée ininterrompue ou sans percée d'une paroi avant de boîtier (28) qui est formée par la première partie de boîtier (16).

14. Dispositif de connexion de charge selon l'une quelconque des revendications précédentes, **caractérisé en ce que** la première partie de boîtier (16) est conçue en forme de coque ou de couvercle, et forme au moins une section partielle d'une paroi avant de boîtier (28) du dispositif de connexion de charge (1), dans lequel dans cette section partielle de la paroi avant de boîtier (28) accessible à un utilisateur du dispositif de connexion de charge (1), aucune percée pour des éléments d'affichage ou de signalisation optique (41) n'est réalisée.

15. Dispositif de connexion de charge selon l'une quelconque des revendications précédentes, **caractérisé en ce que** l'autre partie de boîtier (17) forme au moins la paroi arrière de boîtier (26), et est réalisée sous la forme d'une pièce en matière (25) moulée par injection, en particulier à partir de matière plastique renforcée de fibres de verre.
